# EUROPEAN PATENT APPLICATION

(11) **EP 4 564 399 A1**
(43) Date of publication of application: **04.06.2025**
(21) Application number: 23846649.4
(22) Date of filing: 28.07.2023
(51) Int. Cl.: H01L 21/027

(54) **SUBSTRATE PROCESSING METHOD AND SUBSTRATE PROCESSING SYSTEM**

(30) Priority: 29.07.2022 US 202263393638 P
(71) Applicant: Tokyo Electron Limited, Tokyo 107-6325 (JP)
(72) Inventor: KUMAKURA, Sho, Kurokawa-gun, Miyagi 981-3629 (JP); ONO, Kenta, Kurokawa-gun, Miyagi 981-3629 (JP); NAKANE, Yuta, Kurokawa-gun, Miyagi 981-3629 (JP); NISHIZUKA, Tetsuya, Kurokawa-gun, Miyagi 981-3629 (JP); HONDA, Masanobu, Kurokawa-gun, Miyagi 981-3629 (JP)
(74) Representative: FRKelly
(86) International application number: PCT/JP2023/027676
(87) International publication number: WO 2024/024919

(57) **Abstract**

To provide a technique of adjusting a shape of a development pattern.

A substrate processing method is provided. The method includes (a) providing a substrate on a substrate support, the substrate having an underlying film and a metal-containing resist film on the underlying film, the metal-containing resist film including a first region and a second region; and (b) developing the metal-containing resist film to selectively remove the second region from the metal-containing resist film, in which the (b) includes (b1) removing the second region with respect to the first region at a first selectivity, and (b2) further removing the second region with respect to the first region at a second selectivity different from the first selectivity.

## Description

### Technical Field

An exemplary embodiment of the present disclosure relates to a substrate processing method and a substrate processing system.

### Background Art

Patent Literature 1 discloses a technique for forming a thin film that is able to be patterned using extreme ultraviolet light (hereinafter, referred to as "EUV") on a semiconductor substrate.

### Citation List

### Patent Literature

Patent Literature 1: JP2021-523403 A

### Summary of Invention

### Technical Problem

The present disclosure provides a technique for adjusting a shape of a development pattern.

### Solution to Problem

In one exemplary embodiment of the present disclosure, there is provided a substrate processing method including (a) providing a substrate on a substrate support, the substrate having an underlying film and a metal-containing resist film on the underlying film, the metal-containing resist film including a first region and a second region; and (b) developing the metal-containing resist film to selectively remove the second region from the metal-containing resist film, in which the (b) includes (b1) removing the second region with respect to the first region at a first selectivity, and (b2) further removing the second region with respect to the first region at a second selectivity different from the first selectivity.

### Advantageous Effect of Invention

According to one exemplary embodiment of the present disclosure, it is possible to provide a technique for adjusting a shape of a development pattern.

### Brief Description of Drawings

[Figure 1] Figure 1 is a diagram for describing a configuration example of a heating processing system.
[Figure 2] Figure 2 is a diagram for describing a configuration example in a case where a plasma processing system is used as a development processing system.
[Figure 3] Figure 3 is a diagram for describing a configuration example of a capacitively coupled plasma processing apparatus.
[Figure 4] Figure 4 is a diagram for describing a configuration example of a liquid processing system.
[Figure 5] Figure 5 is a flowchart illustrating a first method.
[Figure 6] Figure 6 is a diagram illustrating an example of a cross-sectional structure of a substrate W provided in step ST11.
[Figure 7] Figure 7 is a view illustrating an example of an underlying film UF of a substrate W.
[Figure 8] Figure 8 is a view illustrating an example of the underlying film UF of the substrate W.
[Figure 9] Figure 9 is a view illustrating an example of a cross-sectional structure of the substrate W after development.
[Figure 10] Figure 10 is a view illustrating an example of a cross-sectional structure of the substrate W after processing in step ST120.
[Figure 11] Figure 11 is a view illustrating an example of a cross-sectional structure of the substrate W after the processing in step ST122.
[Figure 12] Figure 12 is a flowchart for a modification example of the first method.
[Figure 13] Figure 13 is a flowchart illustrating a second method.
[Figure 14] Figure 14 is a view illustrating an example of a cross-sectional structure of the substrate W after processing in step ST220.
[Figure 15] Figure 15 is a view illustrating an example of a cross-sectional structure of the substrate W after processing in step ST222.
[Figure 16] Figure 16 is a block diagram for describing a configuration example of a substrate processing system SS.
[Figure 17] Figure 17 is a flowchart illustrating a method MT.

### Description of Embodiments

Hereinafter, each embodiment of the present disclosure will be described.

In one exemplary embodiment, there is provided a substrate processing method including (a) providing a substrate on a substrate support, the substrate having an underlying film and a metal-containing resist film on the underlying film, the metal-containing resist film including a first region and a second region; and (b) developing the metal-containing resist film to selectively remove the second region from the metal-containing resist film, in which the (b) includes (b1) removing the second region with respect to the first region at a first selectivity, and (b2) further removing the second region with respect to the first region at a second selectivity different from the first selectivity.

In one exemplary embodiment, the first region is an exposed region, and the second region is an unexposed region.

In one exemplary embodiment, the second selectivity is higher than the first selectivity.

In one exemplary embodiment, in the (b), the development is performed by wet development, and the (b) satisfies at least one of (I) a solubility of the metal-containing resist film with respect to a developer used in the (b2) is lower than a solubility of the metal-containing resist film with respect to a developer used in the (b1), (II) a concentration of the developer used in the (b2) is lower than a concentration of the developer used in the (b1), and (III) a temperature of the developer used in the (b2) is lower than a temperature of the developer used in the (b1).

In one exemplary embodiment, in (b), the development is performed by dry development in a chamber, and the (b) satisfies at least one of (I) a temperature of the substrate support in the (b2) is lower than a temperature of the substrate support in the (b1), (II) a pressure in a chamber in the (b2) is lower than a pressure in a chamber in the (b1), (III) an acidity of a second development gas used in the (b2) is lower than an acidity of a first development gas used in the (b1), and (IV) a concentration of the second development gas used in the (b2) is lower than a concentration of the first development gas used in the (b1).

In one exemplary embodiment, the (b1) is performed by dry development using a first processing gas including a first development gas, the (b2) is performed by dry development using a second processing gas including a second development gas, and the (b) satisfies at least one of (I) a temperature of the substrate support in the (b2) is lower than a temperature of the substrate support in the (b1), (II) a pressure in a chamber in the (b2) is lower than a pressure in a chamber in the (b1), (III) an acidity of the second development gas is lower than an acidity of the first development gas, (IV) a concentration of the second development gas is lower than a concentration of the first development gas, and (V) the second processing gas includes a protective gas that protects a side wall of the first region exposed in the (b1) and the (b2), and the first processing gas does not include the protective gas, or includes the protective gas at a partial pressure lower than a partial pressure of the protective gas included in the second processing gas.

In one exemplary embodiment, in the (b), the development is performed by dry development using plasma generated in a chamber, and the (b) satisfies at least one of (I) a level of power of a source RF signal for generating plasma supplied to the chamber in the (b2) is lower than a level of power of a source RF signal in the (b1), and (II) a level of power or voltage of a bias signal supplied to the chamber in the (b2) is lower than a level of power or voltage of a bias signal in the (b1).

In one exemplary embodiment, the (b) further includes reforming the first region between the (b1) and the (b2).

In one exemplary embodiment, reforming the first region includes heating or plasma-processing the substrate.

In one exemplary embodiment, in the substrate processing method, reforming the first region is executed in the same chamber as the (b1).

In one exemplary embodiment, the reforming the first region is executed in a chamber different from the (b1).

In one exemplary embodiment, in the (b1), the development is performed by wet development, and in the (b2), the development is performed by dry development.

In one exemplary embodiment, in the (b), a cycle including the (b1) and the (b2) is repeated a plurality of times.

In one exemplary embodiment, the metal-containing resist film contains at least one metal selected from the group consisting of Sn, Hf, and Ti.

In one exemplary embodiment, the first region is exposed to EUV.

In one exemplary embodiment, switching from the (b1) to the (b2) is performed based on a depth or an aspect ratio of an opening formed in the metal-containing resist film by the development.

In one exemplary embodiment, the first region includes a first portion and a second portion on the underlying film below the first portion, and the (b1) is executed until just before the second portion is exposed or until a part of the second portion is exposed.

In one exemplary embodiment, the substrate processing method further includes (c) etching the underlying film using the metal-containing resist film as a mask after the (b).

In one exemplary embodiment, the substrate processing method further includes at least one of removing a residue of the first region or the second region generated in (b1) after the (b1) and before the (b2); and removing a residue of the first region or the second region generated in the (b1) and/or the (b2) after the (b2) and before the (c).

In one exemplary embodiment, the (c) is executed in the same chamber as a chamber used in the (b).

In one exemplary embodiment, the (c) is executed in a chamber different from a chamber used in the (b).

In one exemplary embodiment, there is provided a substrate processing method including (a) providing a substrate on a substrate support, the substrate having an underlying film and a metal-containing resist film formed on the underlying film, the metal-containing resist film having an exposed first region and an unexposed second region; and (b) dry-developing the metal-containing resist film to selectively remove the second region from the metal-containing resist film, in which the (b) includes (b1) controlling a temperature of the substrate support to a first temperature to remove the second region, and (b2) controlling the temperature of the substrate support to a second temperature lower than the first temperature to remove the second region.

In one exemplary embodiment, the (b) is the dry-developing using HBr, the first temperature is 20°C or higher and 60°C or lower, and the second temperature is -20°C or higher and 20°C or lower.

In an exemplary embodiment, there is provided a substrate processing method including (a) providing a substrate on a substrate support, the substrate having an underlying film and a metal-containing resist film formed on the underlying film, the metal-containing resist film having an exposed first region and an unexposed second region; and (b) dry-developing the metal-containing resist film to selectively remove the second region from the metal-containing resist film, in which the (b) includes (b1) removing the second region using a first processing gas, and (b2) removing the second region using a second processing gas having a lower acidity than the first processing gas.

In one exemplary embodiment, the first processing gas includes a halogen-containing inorganic acid, and the second processing gas includes an organic acid.

In one exemplary embodiment, the first processing gas includes a halogen-containing inorganic acid and an organic acid having a lower flow rate than the halogen-containing inorganic acid, and the second processing gas includes a halogen-containing inorganic acid and an organic acid having a higher flow rate than the halogen-containing inorganic acid.

In one exemplary embodiment, the halogen-containing inorganic acid includes at least one selected from the group consisting of an HBr gas, an HCl gas, a BCl₃ gas, an HF gas, and an HI gas.

In one exemplary embodiment, the organic acid includes at least one selected from the group consisting of a carboxylic acid, a β-dicarbonyl compound, and an alcohol.

In one exemplary embodiment, in the (b), the (b) satisfies at least one of (I) a temperature of the substrate support in the (b2) is lower than a temperature of the substrate support in the (b1), and (II) a pressure in a chamber in the (b2) is lower than a pressure in a chamber in the (b1).

In one exemplary embodiment, in the (b), the (b1) and the (b2) are repeated.

In one exemplary embodiment, in the (b), after a cycle including the (b1) and the (b2) is performed once or more, the (b1) is further performed.

In one exemplary embodiment, the (b) includes removing the second region using plasma generated from the first processing gas and/or the second processing gas after a cycle including the (b1) and the (b2) is executed once or more without using plasma.

In one exemplary embodiment, there is provided a substrate processing system including one or a plurality of substrate processing apparatuses; and a controller, in which the controller is configured to cause, with respect to the one or the plurality of substrate processing apparatuses, (a) providing a substrate on a substrate support, the substrate having an underlying film and a metal-containing resist film on the underlying film, the metal-containing resist film including a first region and a second region, and (b) developing the metal-containing resist film to selectively remove the second region from the metal-containing resist film, and the (b) includes (b1) removing the second region with respect to the first region at a first selectivity, and (b2) further removing the second region with respect to the first region at a second selectivity different from the first selectivity.

Hereinafter, each embodiment of the present disclosure will be described in detail with reference to the drawings. In each drawing, the same or similar elements will be given the same reference numerals, and repeated descriptions will be omitted. Unless otherwise specified, a positional relationship such as up, down, left, and right will be described based on a positional relationship illustrated in the drawings. A dimensional ratio in the drawings does not indicate an actual ratio, and the actual ratio is not limited to the ratio illustrated in the drawings.

### <Configuration Example of Heating Processing System>

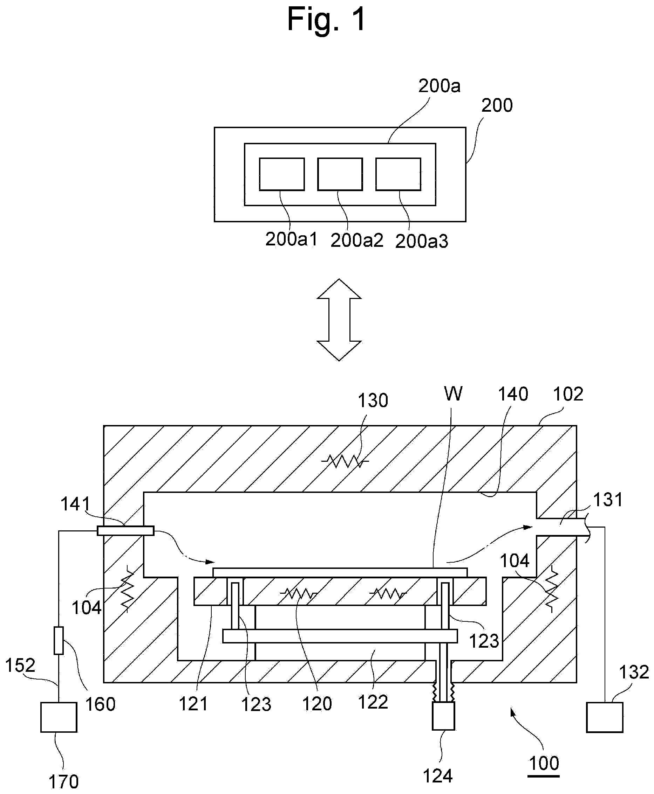

Figure 1 is a diagram for describing a configuration example of a heating processing system. In an embodiment, the heating processing system includes a heating processing apparatus 100 and a controller 200. The heating processing system is an example of a substrate processing system, and the heating processing apparatus 100 is an example of a substrate processing apparatus.

The heating processing apparatus 100 has a processing chamber 102 configured to form a sealed space. The processing chamber 102 is, for example, an airtight cylindrical container, and is configured to be able to adjust the atmosphere inside. A side wall heater 104 is provided on a side wall of the processing chamber 102. A ceiling heater 130 is provided on a ceiling wall (top plate) of the processing chamber 102. A ceiling surface 140 of the ceiling wall (top plate) of the processing chamber 102 is formed as a horizontal flat surface, and a temperature thereof is adjusted by the ceiling heater 130.

A substrate support 121 is provided on a lower side in the processing chamber 102. The substrate support 121 has a substrate support surface on which the substrate W is supported. The substrate support 121 is formed, for example, in a circular shape in a plan view, and the substrate W is placed on a surface (upper surface) thereof that is formed horizontally. A stage heater 120 is embedded in the substrate support 121. The stage heater 120 is able to heat the substrate W placed on the substrate support 121. A ring assembly (not illustrated) may be disposed on the substrate support 121 to surround the substrate W. The ring assembly may include one or a plurality of annular members. By disposing the ring assembly around the substrate W, it is possible to improve the temperature controllability of an outer peripheral region of the substrate W. The ring assembly may be made of an inorganic material or an organic material depending on desired heating processing.

The substrate support 121 is supported in the processing chamber 102 by a support column 122 provided on a bottom surface of the processing chamber 102. A plurality of lifting and lowering pins 123 that is able to be vertically lifted or lowered is provided on an outside of the support column 122 in a circumferential direction. Each of the plurality of lifting and lowering pins 123 is inserted into each of through-holes provided in the substrate support 121. The plurality of lifting and lowering pins 123 is arranged at intervals in the circumferential direction. Lifting and lowering operations of the plurality of lifting and lowering pins 123 are controlled by a lifting and lowering mechanism 124. When the lifting and lowering pin 123 protrudes from the surface of the substrate support 121, the substrate W is able to be delivered between a transport mechanism (not illustrated) and the substrate support 121.

An exhaust port 131 having an opening is provided in a side wall of the processing chamber 102. The exhaust port 131 is connected to an exhaust mechanism 132 via an exhaust pipe. The exhaust mechanism 132 is configured of a vacuum pump, a valve, and the like, and adjusts an exhaust flow rate from the exhaust port 131. A pressure in the processing chamber 102 is adjusted by adjusting the exhaust flow rate and the like by the exhaust mechanism 132. A transport port (not illustrated) of the substrate W is formed on the side wall of the processing chamber 102 to be openable and closable at a position different from a position at which the exhaust port 131 is opened.

In addition, a gas nozzle 141 is provided on the side wall of the processing chamber 102 at a position different from the positions of the exhaust port 131 and the transport port of the substrate W. The gas nozzle 141 supplies a processing gas into the processing chamber 102. The gas nozzle 141 is provided on a side opposite to the exhaust port 131 as viewed from a center portion of the substrate support 121 in the side wall of the processing chamber 102. That is, the gas nozzle 141 is provided to be symmetrical with respect to the exhaust port 131 on a vertical imaginary plane passing through the center portion of the substrate support 121 in the side wall of the processing chamber 102.

The gas nozzle 141 is formed in a rod shape that protrudes from the side wall of the processing chamber 102 toward the center side of the processing chamber 102. A distal end portion of the gas nozzle 141 extends, for example, horizontally from the side wall of the processing chamber 102. The processing gas is discharged into the processing chamber 102 from a discharge port that is open at the distal end of the gas nozzle 141, flows in a direction of a one-dot chain line arrow illustrated in Figure 1, and is exhausted from the exhaust port 131. The distal end portion of the gas nozzle 141 may have a shape that extends obliquely downward toward the substrate W, or may have a shape that extends obliquely upward toward the ceiling surface 140 of the processing chamber 102.

The gas nozzle 141 may be provided, for example, on the ceiling wall of the processing chamber 102. In addition, the exhaust port 131 may be provided on the bottom surface of the processing chamber 102.

The heating processing apparatus 100 includes a gas supply pipe 152 connected to the gas nozzle 141 from the outside of the processing chamber 102. A pipe heater 160 for heating the gas in the gas supply pipe 152 is provided around the gas supply pipe 152. The gas supply pipe 152 is connected to a gas supply 170. The gas supply 170 includes at least one gas source and at least one flow rate controller. The gas supply may include a vaporizer that vaporizes a material in a liquid state.

The controller 200 processes a computer-executable instruction that causes the heating processing apparatus 100 to execute various steps described in the present disclosure. The controller 200 may be configured to control each element of the heating processing apparatus 100 to execute the various steps described here. In an embodiment, a part or all of the controller 200 may be included in the heating processing apparatus 100. The controller 200 may include a processor 200a1, a storage unit 200a2, and a communication interface 200a3. The controller 200 is realized by, for example, a computer 200a. The processor 200a1 may be configured to read out a program from the storage unit 200a2 and execute the read out program to perform various control operations. This program may be stored in the storage unit 200a2 in advance, or may be acquired through a medium when necessary. The acquired program is stored in the storage unit 200a2 and is read out from the storage unit 200a2 and executed by the processor 200a1. The medium may be various storage media readable by the computer 200a, or may be a communication line connected to the communication interface 200a3. The processor 200a1 may be a central processing unit (CPU). The storage unit 200a2 may include a random access memory (RAM), a read only memory (ROM), a hard disk drive (HDD), a solid state drive (SSD), or a combination thereof. The communication interface 200a3 may communicate with the heating processing apparatus 100 through a communication line such as a local area network (LAN).

### <Configuration Example of Plasma System>

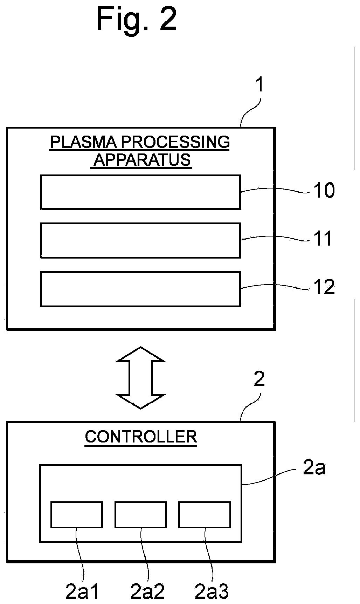

Figure 2 is a diagram for describing a configuration example in a case where a plasma processing system is used as a development processing system. In an embodiment, the plasma processing system includes a plasma processing apparatus 1 and a controller 2. The plasma processing system is an example of a substrate processing system, and the plasma processing apparatus 1 is an example of a substrate processing apparatus. The plasma processing apparatus 1 includes a plasma processing chamber (hereinafter, also simply referred to as a "processing chamber") 10, a substrate support 11, and a plasma generator 12. The plasma processing chamber 10 has a plasma processing space. In addition, the plasma processing chamber 10 has at least one gas supply port for supplying at least one processing gas to the plasma processing space and at least one gas exhaust port for exhausting the gas from the plasma processing space. The gas supply port is connected to a gas supply 20, described later, and the gas exhaust port is connected to an exhaust system 40, described later. The substrate support 11 is disposed in the plasma processing space and has a substrate support surface for supporting a substrate.

The plasma generator 12 is configured to form a plasma from at least one processing gas supplied into the plasma processing space. The plasma formed in the plasma processing space may be a capacitively coupled plasma (CCP), an inductively coupled plasma (ICP), an electron-cyclotron-resonance plasma (ECR), a helicon wave plasma (HWP), a surface wave plasma (SWP), or the like. Further, various types of plasma generators including an alternating current (AC) plasma generator and a direct current (DC) plasma generator may be used. In an embodiment, an AC signal (AC power) used in the AC plasma generator has a frequency in the range of 100 kHz to 10 GHz. Therefore, the AC signal includes a radio frequency (RF) signal and a microwave signal. In an embodiment, an RF signal has a frequency in the range of 100 kHz to 150 MHz.

The controller 2 processes a computer-executable instruction that causes the plasma processing apparatus 1 to execute various steps described in the present disclosure. The controller 2 may be configured to control each element of the plasma processing apparatus 1 to execute the various steps described here. In an embodiment, a part or all of the controller 2 may be included in the plasma processing apparatus 1. The controller 2 is realized by, for example, a computer 2a. The controller 2 may include a processor 2a1, a storage unit 2a2, and a communication interface 2a3. Each configuration of the controller 2 may be the same as each configuration of the above-described controller 200 (see Figure 1).

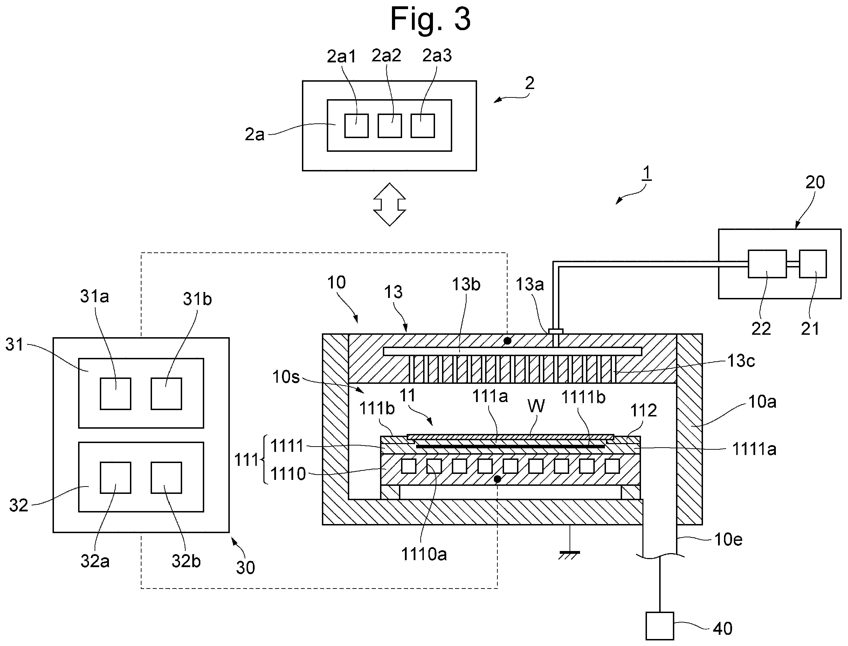

Hereinafter, a configuration example of the capacitively coupled plasma processing apparatus as an example of the plasma processing apparatus 1 will be described. Figure 3 is a diagram for describing the configuration example of the capacitively coupled plasma processing apparatus.

The capacitively coupled plasma processing apparatus 1 includes the plasma processing chamber 10, the gas supply 20, a power supply 30, and the exhaust system 40. In addition, the plasma processing apparatus 1 includes the substrate support 11 and a gas introducer. The gas introducer is configured to introduce at least one processing gas into the plasma processing chamber 10. The gas introducer includes a shower head 13. The substrate support 11 is disposed in the plasma processing chamber 10. The shower head 13 is disposed above the substrate support 11. In an embodiment, the shower head 13 configures at least a part of a ceiling of the plasma processing chamber 10. The plasma processing chamber 10 has a plasma processing space 10s defined by the shower head 13, a side wall 10a of the plasma processing chamber 10, and the substrate support 11. The plasma processing chamber 10 is grounded. The shower head 13 and the substrate support 11 are electrically insulated from a housing of the plasma processing chamber 10.

The substrate support 11 includes a main body 111 and a ring assembly 112. The main body 111 has a center region 111a for supporting the substrate W and an annular region 111b for supporting the ring assembly 112. A wafer is an example of the substrate W. The annular region 111b of the main body 111 surrounds the center region 111a of the main body 111 in plan view. The substrate W is disposed on the center region 111a of the main body 111, and the ring assembly 112 is disposed on the annular region 111b of the main body 111 so as to surround the substrate W on the center region 111a of the main body 111. Therefore, the center region 111a is also referred to as a substrate support surface for supporting the substrate W, and the annular region 111b is also referred to as a ring support surface for supporting the ring assembly 112.

In an embodiment, the main body 111 includes a base 1110 and an electrostatic chuck 1111. The base 1110 includes a conductive member. The conductive member of the base 1110 may function as a lower electrode. The electrostatic chuck 1111 is disposed on the base 1110. The electrostatic chuck 1111 includes a ceramic member 1111a and an electrostatic electrode 1111b disposed in the ceramic member 1111a. The ceramic member 1111a has the center region 111a. In an embodiment, the ceramic member 1111a also has the annular region 111b. Another member that surrounds the electrostatic chuck 1111 may have the annular region 111b, such as an annular electrostatic chuck or an annular insulating member. In this case, the ring assembly 112 may be disposed on the annular electrostatic chuck or the annular insulating member, or may be disposed on both the electrostatic chuck 1111 and the annular insulating member. Further, at least one RF/DC electrode coupled to a RF power supply 31 and/or a DC power supply 32, which will be described later, may be disposed in the ceramic member 1111a. In this case, at least one RF/DC electrode functions as the lower electrode. When a bias RF signal and/or a DC signal, which will be described later, are supplied to at least one RF/DC electrode, the RF/DC electrode is also referred to as a bias electrode. The conductive member of the base 1110 and at least one RF/DC electrode may function as a plurality of lower electrodes. Further, the electrostatic electrode 1111b may function as the lower electrode. Therefore, the substrate support 11 includes at least one lower electrode.

The ring assembly 112 includes one or a plurality of annular members. In an embodiment, one or the plurality of annular members includes one or a plurality of edge rings and at least one cover ring. The edge ring is formed of a conductive material or an insulating material, and the cover ring is formed of an insulating material.

In addition, the substrate support 11 may include a temperature-controlled module configured to adjust at least one of the electrostatic chuck 1111, the ring assembly 112, and the substrate to a target temperature. The temperature-controlled module may include a heater, a heat transfer medium, a flow passage 1110a, or a combination thereof. A heat transfer fluid such as brine or a gas flows in the flow passage 1110a. In an embodiment, the flow passage 1110a is formed in the base 1110, and one or a plurality of heaters is disposed in the ceramic member 1111a of the electrostatic chuck 1111. Further, the substrate support 11 may include a heat transfer gas supply configured to supply the heat transfer gas to a gap between a back surface of the substrate W and the center region 111a.

The shower head 13 is configured to introduce at least one processing gas from the gas supply 20 into the plasma processing space 10s. The shower head 13 has at least one gas supply port 13a, at least one gas diffusion chamber 13b, and a plurality of gas introduction ports 13c. The processing gas supplied to the gas supply port 13a passes through the gas diffusion chamber 13b and is introduced into the plasma processing space 10s from the plurality of gas introduction ports 13c. In addition, the shower head 13 includes at least one upper electrode. In addition to the shower head 13, the gas introducer may include one or a plurality of side gas injectors (SGI) attached to one or a plurality of opening portions formed on the side wall 10a.

The gas supply 20 may include at least one gas source 21 and at least one flow rate controller 22. In an embodiment, the gas supply 20 is configured to supply at least one processing gas to the shower head 13 from each corresponding gas source 21 through each corresponding flow rate controller 22. Each flow rate controller 22 may include, for example, a mass flow controller or a pressure-controlled flow rate controller. Further, the gas supply 20 may include at least one flow rate modulation device that modulates or pulses a flow rate of at least one processing gas.

The power supply 30 includes the RF power supply 31 coupled to the plasma processing chamber 10 via at least one impedance matching circuit. The RF power supply 31 is configured to supply at least one RF signal (RF power) to at least one lower electrode and/or at least one upper electrode. As a result, plasma is formed from at least one processing gas supplied to the plasma processing space 10s. Therefore, the RF power supply 31 may function as at least a part of the plasma generator 12. Further, by supplying the bias RF signal to at least one lower electrode, a bias potential is generated in the substrate W, and an ion component in the formed plasma is able to be drawn into the substrate W.

In an embodiment, the RF power supply 31 includes a first RF generator 31a and a second RF generator 31b. The first RF generator 31a is coupled to at least one lower electrode and/or at least one upper electrode via at least one impedance matching circuit and is configured to generate a source RF signal (source RF power) for plasma generation. In an embodiment, the source RF signal has a frequency in a range of 10 MHz to 150 MHz. In an embodiment, the first RF generator 31a may be configured to generate a plurality of source RF signals having different frequencies. The generated one or plurality of source RF signals is supplied to at least one lower electrode and/or at least one upper electrode.

The second RF generator 31b is coupled to at least one lower electrode via at least one impedance matching circuit and is configured to generate the bias RF signal (bias RF power). The frequency of the bias RF signal may be the same as or different from the frequency of the source RF signal. In an embodiment, the bias RF signal has a frequency lower than the frequency of the source RF signal. In an embodiment, the bias RF signal has a frequency in a range of 100 kHz to 60 MHz. In an embodiment, the second RF generator 31b may be configured to generate a plurality of bias RF signals having different frequencies. The generated one or plurality of bias RF signals is supplied to at least one lower electrode. In addition, in various embodiments, at least one of the source RF signal and the bias RF signal may be pulsed.

In addition, the power supply 30 may include the DC power supply 32 coupled to the plasma processing chamber 10. The DC power supply 32 includes a first DC generator 32a and a second DC generator 32b. In an embodiment, the first DC generator 32a is connected to at least one lower electrode, and is configured to generate the first DC signal. The generated first DC signal is applied to at least one lower electrode. In an embodiment, the second DC generator 32b is connected to at least one upper electrode and is configured to generate a second DC signal. The generated second DC signal is applied to at least one upper electrode.

In various embodiments, the first and second DC signals may be pulsed. In this case, a sequence of voltage pulses is applied to at least one lower electrode and/or at least one upper electrode. The voltage pulse may have a pulse waveform having a rectangular shape, a trapezoidal shape, a triangular shape, or a combination thereof. In an embodiment, a waveform generator for generating the sequence of voltage pulses from the DC signal is connected between the first DC generator 32a and at least one lower electrode. Therefore, the first DC generator 32a and the waveform generator configure the voltage pulse generator. When the second DC generator 32b and the waveform generator configure the voltage pulse generator, the voltage pulse generator is connected to at least one upper electrode. The voltage pulse may have a positive polarity or a negative polarity. In addition, the sequence of voltage pulses may include one or a plurality of positive voltage pulses and one or a plurality of negative voltage pulses in one cycle. The first and second DC generators 32a and 32b may be provided in addition to the RF power supply 31, and the first DC generator 32a may be provided in place of the second RF generator 31b.

The exhaust system 40 may be connected to, for example, a gas exhaust port 10e provided at a bottom portion of the plasma processing chamber 10. The exhaust system 40 may include a pressure regulating valve and a vacuum pump. The pressure in the plasma processing space 10s is adjusted by the pressure regulating valve. The vacuum pump may include a turbo molecular pump, a dry pump, or a combination thereof.

### <Configuration Example of Liquid Processing System>

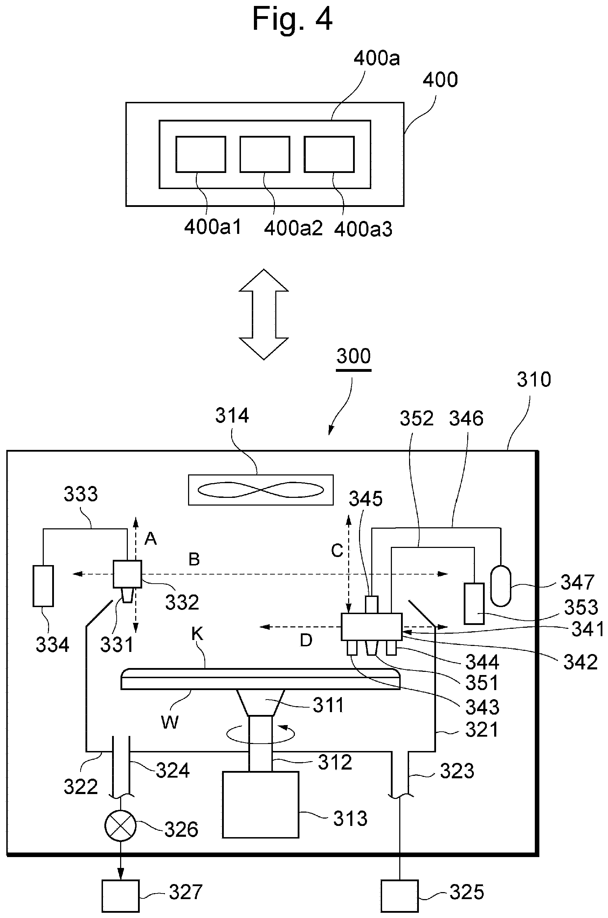

Figure 4 is a diagram for describing a configuration example of a liquid processing system. In an embodiment, the liquid processing system includes a liquid processing apparatus 300 and a controller 400. The liquid processing system is an example of a substrate processing system, and the liquid processing apparatus 300 is an example of a substrate processing apparatus.

As illustrated in Figure 4, the liquid processing apparatus 300 has a spin chuck 311 as a substrate support in a processing chamber 310. The spin chuck 311 holds the substrate W horizontally. The spin chuck 311 is connected to a liftable and lowerable rotating portion 312, and the rotating portion 312 is connected to a rotational drive unit 313 configured by a motor or the like. The substrate W held by the spin chuck 311 is able to be rotated by the driving of the rotational drive unit 313.

A cup 321 is disposed outside the spin chuck 311, and the scattering of a processing liquid (a resist solution, a developer, a cleaning liquid, or the like) or a mist of the processing liquid to the periphery of the cup 321 is prevented. A waste liquid pipe 323 and an exhaust pipe 324 are provided at a bottom portion 322 of the cup 321. The waste liquid pipe 323 communicates with a waste liquid apparatus 325 such as a waste liquid pump. The exhaust pipe 324 communicates with an exhaust apparatus 327 such as an exhaust pump via a valve 326.

A blower apparatus 314 that supplies air having a required temperature and humidity to the inside of the cup 321 as downflow is provided above the processing chamber 310 of the liquid processing apparatus 300.

When forming a puddle of the processing liquid on the substrate W, a processing liquid supply nozzle 331 is used. The processing liquid supply nozzle 331 is provided on, for example, a nozzle support 332 such as an arm, and the nozzle support 332 is liftable and lowerable by a drive mechanism as illustrated by a reciprocating arrow A indicated by a broken line in the drawing, and is movable horizontally as illustrated by a reciprocating arrow B indicated by a broken line in the drawing. A processing liquid (resist solution, developer, or the like) is supplied from a processing liquid source 334 to the processing liquid supply nozzle 331 via a supply pipe 333.

In a case where a so-called long nozzle including a discharge port having a length equal to or greater than a diameter of the substrate W is used in forming the puddle, the puddle of the processing liquid is able to be formed on the substrate W by scanning the substrate W from one end portion to the other end portion. In addition, in a case of a so-called straight type nozzle that discharges a liquid to form a liquid column having a sufficiently small width compared to the diameter of the substrate W, the entire surface of the substrate W is able to be diffused with the processing liquid and a puddle of the processing liquid is able to be formed on the substrate W by positioning the discharge port above the center of the substrate W and discharging the processing liquid while rotating the substrate W. In addition, the formation of the puddle of the processing liquid may be performed by scanning the substrate W with a straight type nozzle in the same manner as the long nozzle, or by arranging a plurality of discharge ports that discharges a liquid, such as the straight type, on the substrate W and supplying the processing liquid from each of the discharge ports.

A gas nozzle 341 has a nozzle body 342. The nozzle body 342 is provided at the nozzle support such as an arm, and the nozzle support is liftable and lowerable by a drive mechanism as illustrated by a reciprocating arrow C indicated by a broken line, and is movable horizontally as illustrated by a reciprocating arrow D indicated by a broken line in the drawing.

The gas nozzle 341 has two nozzle discharge ports 343 and 344. The nozzle discharge ports 343 and 344 are formed by being branched from a gas flow passage 345. The gas flow passage 345 communicates with a gas source 347 via a gas supply pipe 346. As the inert gas or the non-oxidizing gas, for example, nitrogen gas is prepared in the gas source 347. For example, when nitrogen gas is supplied from the gas flow passage 345 to the gas nozzle 341, the nitrogen gas is discharged from the respective nozzle discharge ports 343 and 344.

In addition, the gas nozzle 341 is provided with a cleaning liquid supply nozzle 351 for cleaning the processing liquid after the liquid processing from the substrate W. The cleaning liquid supply nozzle 351 communicates with a cleaning liquid source 353 via a cleaning liquid supply pipe 352. As the cleaning liquid, for example, pure water is used. The cleaning liquid supply nozzle 351 is positioned between the two nozzle discharge ports 343 and 344 described above, but the position thereof is not limited thereto. The cleaning liquid supply nozzle 351 may be configured independently of the gas nozzle 341.

The controller 400 processes a computer-executable instruction that causes the liquid processing apparatus 300 to execute various steps described in the present disclosure. The controller 400 may be configured to control each element of the liquid processing apparatus 300 to execute the various steps described here. In an embodiment, a part or all of the controller 400 may be included in the liquid processing apparatus 300. The controller 400 is realized by, for example, a computer 400a. The computer 400a may include a processor 400a1, a storage unit 400a2, and a communication interface 400a3. Each configuration of the controller 400 may be the same as each configuration of the controller 200 (see Figure 1) described above.

### <First Embodiment of Substrate Processing Method>

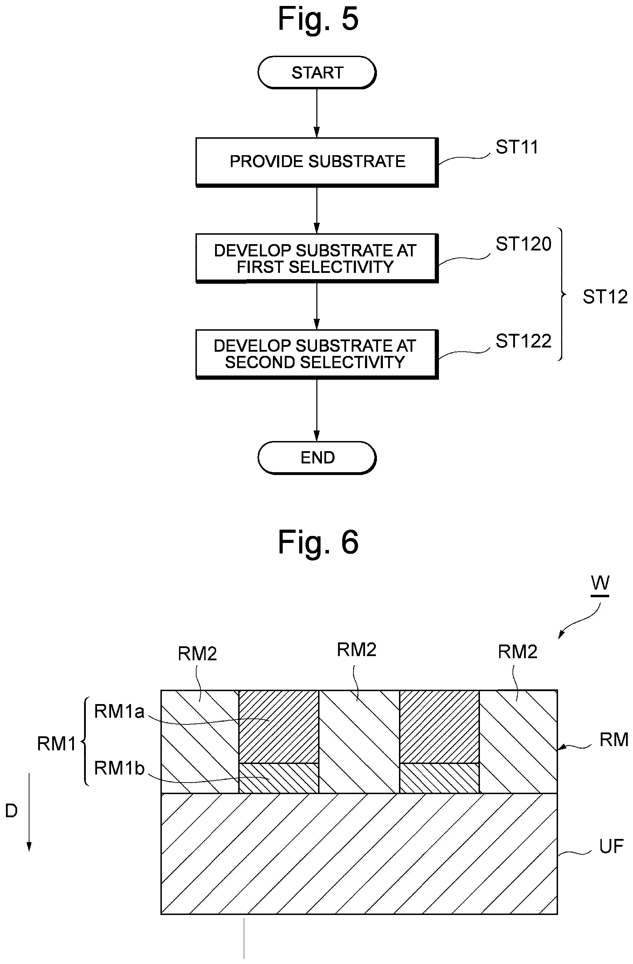

Figure 5 is a flowchart illustrating an exemplary substrate processing method (hereinafter, also referred to as a "first method") according to the first embodiment. As illustrated in Figure 5, the first method includes a step ST11 of providing a substrate and a step ST12 of developing the substrate. In an embodiment, the development processing in the step ST12 is performed by a dry process (hereinafter, also referred to as "dry development") using a processing gas. In an embodiment, the development processing in the step ST12 is performed by a wet process (hereinafter, also referred to as "wet development") using a developer. In an embodiment, the development processing in the step ST12 is performed using both wet development and dry development.

The first method may be executed by using any one of the above-described substrate processing systems (see Figures 1 to 4), or may be executed by using two or more of these substrate processing systems. For example, the first method may be executed by the heating processing system (see Figure 1). In the following, a case where the controller 200 controls each unit of the heating processing apparatus 100 to execute the first method on the substrate W will be described as an example.

### (Step ST11: Provision of Substrate)

First, in step ST11, the substrate W is provided in the processing chamber 102 of the heating processing apparatus 100. The substrate W is provided on the substrate support 121 via the lifting and lowering pin 123. After the substrate W is disposed on the substrate support 121, the temperature of the substrate support 121 is adjusted to a set temperature. The temperature adjustment of the substrate support 121 may be performed by controlling an output of one or more heaters of the side wall heater 104, the stage heater 120, the ceiling heater 130, and the pipe heater 160 (hereinafter, also referred to as "each heater"). In the present processing method, the temperature of the substrate support 121 may be adjusted to the set temperature before the step ST11. That is, the substrate W may be provided on the substrate support 121 after the temperature of the substrate support 121 is adjusted to the set temperature.

Figure 6 is a diagram illustrating an example of a cross-sectional structure of the substrate W provided in step ST11. The substrate W includes an underlying film UF and a resist film RM formed on the underlying film UF. The substrate W may be used for manufacturing a semiconductor device. The semiconductor device includes, for example, a memory device such as a DRAM or a 3D-NAND flash memory, and a logic device.

The resist film RM is a metal-containing resist film containing a metal. The metal may include at least one metal selected from the group consisting of Sn, Hf, and Ti, as an example. In an example, the resist film RM may contain Sn, and may contain tin oxide (SnO) and tin hydroxide (Sn-OH bond). The resist film RM may further contain an organic substance.

As illustrated in Figure 6, the resist film RM has an exposed first region RM1 and an unexposed second region RM2. The first region RM1 is a region exposed to EUV light, that is, an EUV exposure region. The second region RM2 is a region that is not exposed to the EUV light, that is, an unexposed region. A film thickness of the first region RM1 may be smaller than a film thickness of the second region RM2.

The underlying film UF may be an organic film, a dielectric film, a metal film, or a semiconductor film, or a film stack thereof formed on a silicon wafer. In an embodiment, the underlying film UF includes, for example, at least one selected from the group consisting of a silicon-containing film, a carbon-containing film, and a metal-containing film.

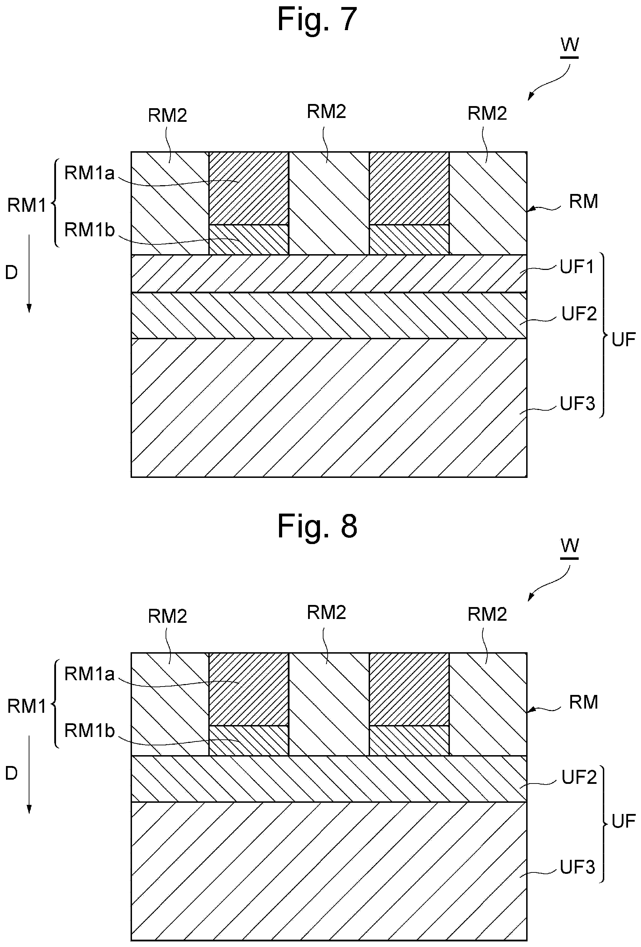

Figures 7 and 8 are views illustrating an example of the underlying film UF of the substrate W, respectively. As illustrated in Figure 7, the underlying film UF may be configured of a first film UF1, a second film UF2, and a third film UF3. As illustrated in Figure 8, the underlying film UF may be configured of the second film UF2 and the third film UF3.

The first film UF1 is, for example, a spin-on glass (SOG) film, a SiC film, a SiON film, a Si-containing antireflection film (SiARC), or an organic film. The second film UF2 is, for example, a spin-on carbon (SOC) film, an amorphous carbon film, or a silicon-containing film. The third film UF3 is, for example, a silicon-containing film. The silicon-containing film is, for example, a silicon oxide film, a silicon nitride film, a silicon acid nitride film, a silicon carbon nitride film, a polycrystalline silicon film, or a carbon-containing silicon film. The third film UF3 may be configured of a plurality of stacked silicon-containing films. For example, the third film UF3 may be configured of a silicon oxide film and a silicon nitride film which are alternately stacked. In addition, the third film UF3 may be configured of a silicon oxide film and a polycrystalline silicon film which are alternately stacked. In addition, the third film UF3 may be a film stack including a silicon nitride film, a silicon oxide film, and a polycrystalline silicon film. In addition, the third film UF3 may be configured of a stacked silicon oxide film and silicon carbon nitride film. In addition, the third film UF3 may be a film stack including a silicon oxide film, a silicon nitride film, and a silicon carbon nitride film.

In an embodiment, the substrate W is formed as follows. First, a photoresist film containing a metal is formed on an underlying film which is subjected to an adhesiveness processing or the like. The film formation may be carried out by a dry process, may be carried out by a wet process such as a solution coating method, or may be carried out by both the dry process and the wet process. Surface reforming processing may be performed on the underlying film before the film formation of the photoresist film. The substrate after the film formation of the photoresist film is subjected to a heating processing, that is, a post apply bake (PAB). The post apply baked substrate may be subjected to additional heating processing. The wafer after the heating processing is transported to an exposure apparatus, and the photoresist film is irradiated with EUV light through an exposure mask (reticle). As a result, the substrate W including the underlying film UF and the resist film RM having the exposed first region RM1 and the unexposed second region RM2 is formed. The first region RM1 is a region corresponding to an opening provided in the exposure mask (reticle). The second region RM2 is a region corresponding to a pattern provided on the exposure mask (reticle). The EUV light has, for example, a wavelength in a range of 10 to 20 nm. The EUV light may have a wavelength in a range of 11 to 14 nm, and has a wavelength of 13.5 nm in an example. The substrate after the exposure is transported from the exposure apparatus to the heating processing apparatus under atmosphere control, and is subjected to a heating processing, that is, a post-exposure bake (PEB). The substrate W after the PEB may be subjected to additional heating processing.

In the first region RM1 exposed to EUV, a portion where an exposure reaction is weak may occur along a thickness direction of the resist film RM (a direction of the arrow D in Figures 6 to 8, hereinafter, also referred to as a "depth direction"). This is considered to be due to a stochastic fluctuation of the photon distribution of the EUV light and a shallowness of a focal depth. In the examples illustrated in Figures 6 to 8, the first region RM1 has a first portion RM1a and a second portion RM1b having a weaker exposure reaction than the first portion RM1a along the thickness direction. The second portion RM1b is a portion that is in contact with the base layer UF in the first region RM1.

Since the exposure reaction is weak, the second portion RM1b has properties similar to those of the film in the second region RM2 which is the unexposed region. Therefore, in the resist film RM illustrated in Figures 6 to 8, it is difficult to obtain a development contrast (a ratio of a development speed of the exposed region to a development speed of the unexposed region) along the thickness direction. When the resist film RM is developed under the same conditions along the thickness direction, as the development proceeds, the side surface of the first region RM1 on the lower side (second portion RM1b) is easily removed together with the second region RM2.

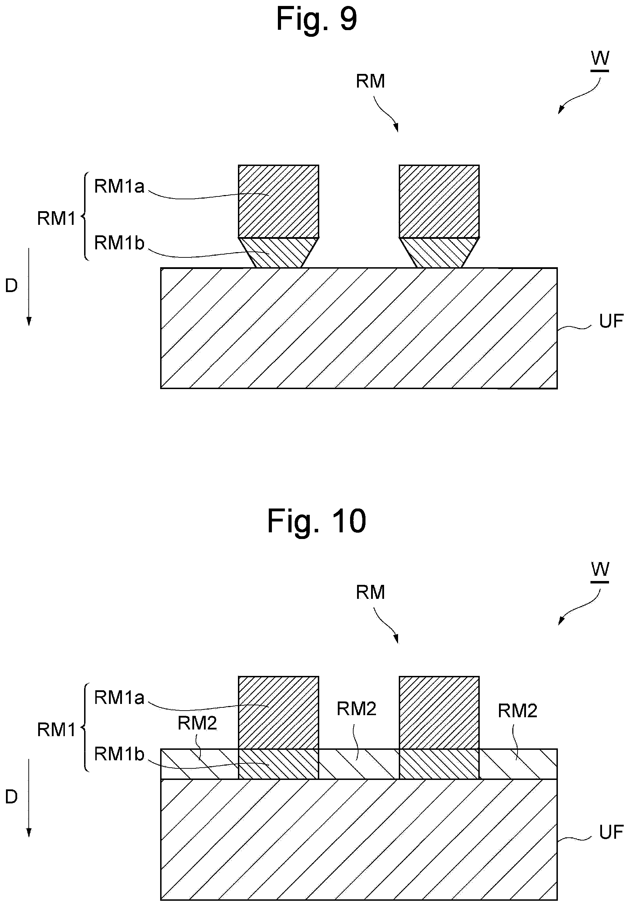

Figure 9 is a view illustrating an example of a cross-sectional structure of the substrate W after development. Figure 9 is an example of a case where the substrate W illustrated in Figure 6 is developed under the same conditions along the thickness direction. In the example illustrated in Figure 9, in the first region RM after development, a cross-sectional dimension of the second portion RM1b is reduced along the thickness direction, and the first region RM has an inverted tapered shape. It is considered that this is because the second portion RM1b of the first region RM1 has a smaller development contrast with respect to the second region RM2 than the first portion RM1a in the thickness direction, and thus the second portion RM1b is easily removed by development together with the second region RM2. Therefore, in the first method, the step ST121 and the step ST122 are developed under different conditions. For example, in the first method, development is performed with different development contrasts in the step ST121 and the step ST122. As a result, even in a case where the intensity of the exposure reaction in the resist film RM varies in the thickness direction, the shape of the development pattern is able to be adjusted, and the deterioration of the pattern shape or the roughness may be suppressed.

### (Step ST12: Development of Substrate)

Next, in step ST12, the resist film RM of the substrate W is developed, and the second region RM2 is selectively removed. The step ST12 includes a step ST120 of developing the substrate at a first selectivity and a step ST122 of developing the substrate at a second selectivity different from the first selectivity.

### (Step ST120: Development at First Selectivity)

First, in step ST120, a first processing gas including the first development gas is supplied into the processing chamber 102 via the gas nozzle 141. In an embodiment, the first development gas includes a halogen-containing gas. The halogen-containing gas may be a gas containing a halogen-containing inorganic acid, and may be a gas containing Br or Cl. The gas containing a halogen-containing inorganic acid may be a gas containing a hydrogen halide and/or a boron halide. The gas containing the halogen-containing inorganic acid is, for example, at least one selected from the group consisting of an HBr gas, a BCl₃ gas, an HCl gas, an HF gas, and an HI gas. In an embodiment, the first development gas may be a gas containing an organic acid. The gas containing an organic acid may be, for example, a gas containing at least one selected from the group consisting of a carboxylic acid, a β-dicarbonyl compound, and an alcohol. In an embodiment, the first development gas is a gas containing a carboxylic acid. The carboxylic acid may be, for example, formic acid (HCOOH), acetic acid (CH₃COOH), trichloroacetic acid (CCl₃COOH), monofluoroacetic acid (CFH₂COOH), difluoroacetic acid (CF2FCOOH), trifluoroacetic acid (CF₂COOH), chloro-difluoroacetic acid (CClF₂COOH), sulfur-containing acetic acid, thioacetic acid (CH₃COSH), thioglycolic acid (H SCH₂COOH), trifluoroacetic acid anhydride ((CF₃CO)₂O), or acetic acid anhydride ((CH₃CO)₂O). In an embodiment, the first development gas includes a β-dicarbonyl compound. The β-dicarbonyl compound may be, for example, acetylacetone (CH₃C(O)CH₂C(O)CH₃), trichloroacetylacetone (CCl₃C(O)CH₂C(O)CH₃), hexachloroacetylacetone (CCl₃C(O)CH₂C(O)CCl₃), trifluoroacetylacetone (CF₃C(O)CH₂C(O)CH₃), or hexafluoroacetylacetone (HFAc, CF₃C(O)CH₂C(O)CF₃). In an embodiment, the first development gas includes an alcohol. As the alcohol may be, for example, nonafluoro-tert-butyl alcohol ((CF₃)₃C-OH).

In an embodiment, the first development gas is a gas containing trifluoroacetic acid. In an embodiment, the first development gas includes halogenated organic acid vapor. In an example, the first development gas includes at least one selected from the group consisting of trifluoroacetic acid anhydride, acetic acid anhydride, trichloroacetic acid, CFH₂COOH, CF₂HCOOH, chlorodifluoroacetic acid, sulfur-containing acetic acid, thioacetic acid, and thioglycolic acid. In an embodiment, the first development gas is a mixed gas of a carboxylic acid and a hydrogen halide or a mixed gas of acetic acid and formic acid. In an embodiment, the first processing gas is a gas containing acetic acid.

In the step ST120, the second region RM2 of the resist film RM is removed at the first selectivity with respect to the first region RM1. In the first method, the "selectivity" is also referred to as a development contrast, and is a ratio of the development speed of the second region RM2 to the development speed of the first region RM1. The first selectivity may be appropriately set to a range (that is, a value greater than 1) in which the second region RM2 is selectively removed with respect to the first region RM1. The first selectivity may be set to be relatively low to the extent that a part of the first region RM1 is removed. In this case, even in a case where there is a portion other than the first region RM1 (portion corresponding to the opening of the exposure mask) that has been exposed to EUV, the resist film of the portion is able to be removed, and the portion remaining as a residue is able to be suppressed.

The step ST120 may be executed until the second region RM2 is removed to a given depth or until the opening formed by the development has a given aspect ratio. The given depth or aspect ratio may be set based on the degree of progress of the exposure reaction of the first region RM1 (in an example, based on the thickness of the first portion RM1a or the second portion RM1b). In an embodiment, the step ST120 may be executed until just before the second portion RM1b of the first region RM1 is exposed or until partially exposed.

Figure 10 is a view illustrating an example of a cross-sectional structure of the substrate W after the processing in step ST120. In the example illustrated in Figure 10, the second region RM2 of the resist film RM is selectively removed with respect to the first region RM1, and the side surface of the first portion RM1a of the first region is exposed (the second portion RM1b is not exposed at this stage).

### (Step ST122: Development with Second Selectivity)

In the step ST122, a second processing gas including a second development gas is supplied into the processing chamber 102 via the gas nozzle 141. The second development gas may be the same as or different from that in the step ST120.

In the step ST122, the second region RM2 of the resist film RM is removed at the second selectivity different from the first selectivity with respect to the first region. The selectivity may be made different from the first selectivity by changing, for example, any one or more of development conditions such as the set temperature of the substrate W or the substrate support 11, the pressure in the processing chamber 102, and the type and concentration (partial pressure) of the processing gas from the step ST120.

In an embodiment, the second selectivity is higher than the first selectivity. For example, in step ST122, any one or more of the following (I) to (IV) may be executed to make the second selectivity higher than the first selectivity.

(I) In the step ST122, the set temperature of the substrate W or the substrate support 121 is set to be lower than that in the step ST120. For example, in a case where the HBr gas is used as the second development gas, the set temperature of the substrate support 121 in the step ST120 may be set to 20°C or higher and 60°C or lower or 40°C or higher and 60°C or lower, and the set temperature of the substrate support 121 in the step ST122 may be set to -20°C or higher and lower than 20°C. For example, in a case where the BCl₃ gas is used as the second development gas, the set temperature of the substrate support 121 in the step ST120 may be set to 120°C or higher and 180°C or lower, and the set temperature of the substrate support 121 in the step ST122 may be set to 60°C or higher and lower than 120°C.
(II) In the step ST122, the pressure in the processing chamber 102 is set to be lower than that in the step ST120. For example, in a case where the HBr gas is used as the second development gas, the pressure in the processing chamber 102 in the step ST120 may be set to 1 Torr or more and 10 Torr or less, and the pressure in the processing chamber 102 in the step ST122 may be set to 0.01 Torr or more and 1 Torr or less.
(III) In the step ST122, the acidity of the second development gas is set to be lower than the acidity of the first development gas. That is, in the step ST122, the second development gas having a larger acid dissociation constant (pKa) than the first development gas used in the step ST120 is used. For example, the development gas may be changed from a gas containing the halogen-containing inorganic acid (step ST120) to a gas containing the organic acid (step ST122). In an example, the development gas may be changed from the HBr gas or the BCl₃ gas (step ST120) to a carboxylic acid gas such as an acetic acid gas (step ST122). In addition, for example, the development gas may be changed from a gas (step ST120) containing a halogen containing-inorganic acid having a high acidity to a gas (step ST122) containing a halogen-containing inorganic acid having a low acidity, or may be changed from a gas (step ST120) containing an organic acid having a high acidity to a gas (step ST122) containing an organic acid having a low acidity. In an example, the development gas may be changed from the HBr gas (step ST120) to the BCl₃ gas (step ST122). In addition, for example, in a case where a mixed gas is used as the development gas, the flow rate (partial pressure) of the "gas having a relatively large acid dissociation constant (pKa) " in the mixed gas may be increased in the second development gas as compared with the first development gas. For example, in a case where the first development gas and the second development gas in the step ST120 and the step ST122 are each the mixed gas of the HBr gas and the carboxylic acid gas, the flow rate (partial pressure) of the carboxylic acid gas in the second development gas may be increased as compared with the flow rate (partial pressure) of the carboxylic acid gas in the first development gas.
(IV) In the step ST122, the concentration (partial pressure) of the development gas in the processing gas is set to be lower than the concentration (partial pressure) of the development gas in the processing gas in the step ST120. For example, in a case where a mixed gas including a development gas and noble gas such as Ar is used as the processing gas, the concentration (partial pressure) of the development gas in the step ST122 is lower than the concentration (partial pressure) of the development gas in the step ST120.

The step ST122 may be executed until the second region RM2 is removed and the underlying film UF is exposed. The step ST122 may be performed until the underlying film UF is partially removed (over-etched) in the depth direction.

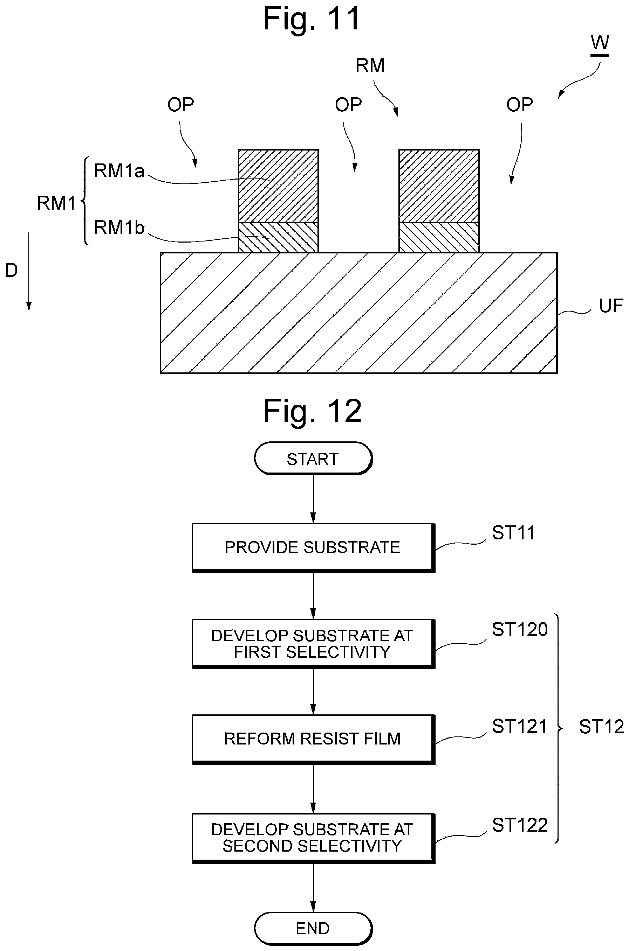

Figure 11 is a view illustrating an example of a cross-sectional structure of the substrate W after the processing in step ST122. In the example illustrated in Figure 11, the second region RM2 of the resist film RM is removed, and an opening OP is formed. The opening OP is defined by a side surface of the first region RM1. The opening OP is a space on the underlying film UF surrounded by the side surface. The opening OP has a shape corresponding to the second region RM2 (a shape corresponding to the exposure mask pattern used for the EUV exposure as a result) in a plan view of the substrate W. The shape may be, for example, a circle, an ellipse, a rectangle, a line, or a shape in which one or more of these are combined. A plurality of openings OP may be formed in the resist film RM. The plurality of openings OP may each have a linear shape and may be arranged at regular intervals to form a line-and-space pattern. In addition, the plurality of the openings OP may be arranged in a lattice shape to form a pillar pattern.

As described above, the first method includes the step ST120 of performing development at the first selectivity and the step ST122 of performing development at the second selectivity different from the first selectivity. In this manner, the shape of the development pattern is able to be adjusted. In addition, even in a case where the intensity of the exposure reaction is different in the thickness direction in the resist film RM, the second region RM2 is able to be removed with respect to the first region RM1 at an appropriate selectivity, and the deterioration of the pattern shape or the roughness may be suppressed.

Figure 12 is a flowchart for a modification example of the first method. As illustrated in Figure 12, the step ST12 may include a step ST121 of reforming the resist film between the step ST120 and the step ST122.

In the step ST121, the resist film RM is subjected to reforming processing. In an embodiment, the reforming processing is performed by heating processing the substrate W. The heating processing of the substrate W may be performed, for example, by controlling one or more outputs of each heater of the heating processing apparatus 100 to adjust the temperature of the substrate support 121. The substrate W may be heated, for example, to 180°C or higher. The substrate W may be heated, for example, to a temperature of 190°C or higher and 240°C or lower. The substrate W may be heated, for example, to a temperature of 190°C or higher and 220°C or lower. The inside of the chamber for heating the substrate W may be an atmosphere including air, an N₂ gas, and/or an H₂O gas. The metal film density of the first region RM1 may be increased and the development resistance may be improved by the reforming processing. Since a part of the second region RM2 is removed in the step ST121 (see Figure 10), the reforming is likely to proceed even in the portion RM1b of the first region RM1 where the exposure reaction is weak. As a result, a decrease in development contrast along the depth direction of the resist film RM may be suppressed.

The heating processing in the step ST121 may be performed in the processing chamber 102 of the heating processing apparatus 100 different from the step ST120 or the step ST122. In addition, the heating processing in the step ST121 may be performed using an apparatus different from the heating processing apparatus 100. For example, the substrate W may be heated by irradiating the substrate W with electromagnetic waves using an apparatus that generates electromagnetic waves such as infrared light or microwaves.

In an embodiment, the reforming processing in the step ST121 is performed by plasma processing. The plasma processing may be performed, for example, by transporting the substrate W from the heating processing apparatus 100 to the plasma processing apparatus 1 and exposing the substrate W to plasma generated in the plasma processing apparatus 1. The plasma processing may be performed, for example, by introducing the processing gas excited by a remote plasma source into the processing chamber 102 of the heating processing apparatus 100. The processing gas for plasma generation may be an inert gas. The inert gas is noble gas such as He, Ar, Ne, Kr, and Xe, or nitrogen gas, for example.

In an embodiment, the first method may be executed using the plasma processing system (see Figures 2 and 3). For example, the dry development of the resist film RM may be performed by providing the substrate W on the substrate support 11 in the processing chamber 10 of the plasma processing apparatus 1 (step ST11) and supplying the processing gas into the processing chamber 10 from the gas supply 20 (step ST12). The processing gas may be the same as in a case where the heating processing system is used. In the step ST120 and/or the step ST122, the source RF signal may be supplied to the lower electrode of the substrate support 11 and/or the upper electrode of the shower head 13. In addition, a bias signal may be supplied to the lower electrode of the substrate support 11. In this case, plasma is generated from the processing gas in the processing chamber 10, and active species such as ions and radicals in the plasma are attracted to the substrate W, and development may be promoted.

In a case where the plasma processing system is used, in the step ST122, development may be performed at the second selectivity different from the first selectivity by changing any one or more of the development conditions from the step ST120. The changed development conditions include, for example, the set temperature of the substrate W or the substrate support 11, the pressure in the processing chamber 10, the type and the concentration (partial pressure) of the processing gas, and a power level of the source RF signal or a power level or a voltage level of the bias signal.

In a case where the plasma processing system is used, in step ST122, for example, any one or more of the following (I) to (IV) may be executed to increase the second selectivity to be higher than the first selectivity.

(I) In the step ST122, the set temperature of the substrate W or the substrate support 11 is set to be lower than that in the step ST120. For example, in a case where the HBr gas is used as the processing gas, the set temperature of the substrate support 11 in the step ST120 may be 20°C or higher and 60°C or lower or 40°C or higher and 60°C or lower, and the set temperature of the substrate support 11 in the step ST122 may be -20°C or higher and lower than 20°C. For example, in a case where the BCl₃ gas is used as the processing gas, the set temperature of the substrate support 11 in the step ST120 may be set to 120°C or higher and 180°C or lower, and the set temperature of the substrate support 121 in the step ST122 may be set to 60°C or higher and lower than 120°C. The substrate support 11 may be adjusted to a set temperature by a temperature-controlled module. In addition, the substrate support 11 may be adjusted to the set temperature by controlling the pressure of the heat transfer gas (for example, He) between the electrostatic chuck 1111 and the back surface of the substrate W.
(II) In the step ST122, the pressure in the processing chamber 10 is set to be lower than that in the step ST120. For example, the pressure in the processing chamber 10 in the step ST120 may be set to 1 Torr or more and 10 Torr or less, and the pressure in the processing chamber 10 in the step ST122 may be set to 0.01 Torr or more and 1 Torr or less.
(III) In the step ST122, the acidity of the second development gas is set to be lower than the acidity of the first development gas. That is, in the step ST122, the second development gas having a larger acid dissociation constant (pKa) than the first development gas used in the step ST120 is used. For example, the development gas may be changed from a gas containing the halogen-containing inorganic acid (step ST120) to a gas containing the organic acid (step ST122). In an example, the development gas may be changed from the HBr gas or BCl₃ (step ST120) to a carboxylic acid gas such as an acetic acid gas (step ST122). In addition, for example, the development gas may be changed from a gas (step ST120) containing a halogen containing-inorganic acid having a high acidity to a gas (step ST122) containing a halogen-containing inorganic acid having a low acidity, or may be changed from a gas (step ST120) containing an organic acid having a high acidity to a gas (step ST122) containing an organic acid having a low acidity. In an example, the development gas may be changed from the HBr gas (step ST120) to the BCl₃ gas (step ST122). In addition, for example, in a case where a mixed gas is used as the development gas, the flow rate (partial pressure) of the "gas having a relatively large acid dissociation constant (pKa) " in the mixed gas may be increased in the second development gas as compared with the first development gas. For example, in a case where the first development gas and the second development gas in the step ST120 and the step ST122 are each the mixed gas of the HBr gas and the carboxylic acid gas, the flow rate (partial pressure) of the carboxylic acid gas in the second development gas may be increased as compared with the flow rate (partial pressure) of the carboxylic acid gas in the first development gas.
(IV) In the step ST122, the concentration (partial pressure) of the development gas in the processing gas is set to be lower than the concentration (partial pressure) of the development gas in the processing gas in the step ST120. For example, in a case where a mixed gas including a development gas and noble gas such as Ar is used as the processing gas, the concentration (partial pressure) of the development gas in the step ST122 is lower than the concentration (partial pressure) of the development gas in the step ST120.
   In a case where plasma is formed from the processing gas in the step ST120 and the step ST122, at least any one of the following (V) and (VI) may be executed in addition to or instead of the above (I) to (IV). As a result, the second selectivity may be higher than the first selectivity.
(V) In the step ST122, the power level of the source RF signal supplied to the processing chamber 10 is set to be lower than the power level of the source RF signal in the step ST120.
(VI) In the step ST122, the power or the voltage level of the bias signal supplied to the processing chamber 10 is set to be smaller than the power or the voltage level of the bias signal in the step ST120.

In a case where the substrate W is subjected to dry development using the heating processing system or the plasma processing system, the first method may include a desorption step. The desorption step includes removing (descumming) scum from the surface of the resist film RM or smoothing the surface of the resist film RM with an inert gas such as helium or plasma of the inert gas. The desorption step may be executed after the step ST12. The desorption step may be repeatedly executed once or multiple times between the step ST120 and the step ST122. In addition, the desorption step may be executed before the step ST12 (step ST122) and a step of etching the underlying film UF described later instead of between the step ST120 and the step ST122, or together between the step ST120 and the step ST122.

In an embodiment, the first method may be executed by the liquid processing system (see Figure 4). That is, the wet development of the resist film RM may be performed by providing the substrate to the spin chuck 311 in the processing chamber 310 of the liquid processing apparatus 300 (step ST11) and supplying the developer from the processing liquid supply nozzle 331 to the substrate W (step ST12). The developer may contain, for example, an aromatic compound such as benzene, xylene, or toluene, an ester such as propylene glycol monomethyl ester acetate, ethyl acetate, ethyl lactate, n-butyl acetate, or butyrolactone, an alcohol such as 4-methyl-2-pentanol, 1-butanol, isopropanol, 1-propanol, or methanol, a ketone such as methyl ethyl ketone, acetone, cyclohexanone, 2-heptanone, or 2-octanone, or an ether such as tetrahydrofuran, dioxane, or anisole.

In a case where the liquid processing system is used, in step ST122, for example, by changing any one or more of the solubility, concentration, and temperature of the developer from Step ST120, development may be performed at the second selectivity different from the first selectivity.

In a case where the liquid processing system is used, in step ST122, for example, any one or more of the following (I) to (III) may be executed to set the second selectivity to be higher than the first selectivity.

(I) The solubility of the resist film RM in the developer used in the step ST122 is set to be lower than the solubility of the resist film in the developer used in the step ST120.
(II) The concentration of the developer used in the step ST122 is set to be lower than the concentration of the developer used in the step ST120, for example, by increasing the dilution degree of the developer.
(III) The temperature of the developer used in the step ST122 is set to be lower than the temperature of the developer used in the step ST120. For example, in the step ST120, the temperature of the developer may be controlled to 30°C or higher and 90°C or lower, and in the step ST122, the temperature of the developer may be controlled to 10°C or higher and 60°C or lower.

In an embodiment, the development processing in the step ST12 may be performed by both dry development and wet development. For example, the step ST120 may be executed by wet development using the liquid processing system (see Figure 4), and the step ST122 may be executed by dry development using the heating processing system (see Figure 1) or the plasma processing system (see Figures 2 and 3). In a case where the wet development is performed before the dry development, contamination due to infiltration of the developer into the underlying film UF or pattern collapse of the resist film due to the surface tension of the developer is able to be suppressed. The step ST120 may be executed by dry development, and the step ST122 may be executed by wet development.

In an embodiment, the development processing in the step ST12 may be performed by both the heating processing and the plasma processing. For example, the step ST120 may be executed by the heating processing, and the step ST122 may be executed by the plasma processing, or the step ST120 may be executed by the plasma processing, and the step ST122 may be executed by the heating processing.

In an embodiment, in the step ST12, the cycle including the step ST120 and the step ST122 may be repeated a plurality of times. In this case, the cycle of the step ST120 and the step ST122 may be repeated a plurality of times only by the dry development, or may be repeated a plurality of times only by the wet development. In addition, after performing the cycles of the step ST120 and the step ST122 once or more by the wet development, the cycles of the step ST120 and the step ST122 may be performed once or more by the dry development. In addition, the cycle of the step ST120 performed by the wet development and the step ST122 performed by the dry development may be repeated a plurality of times. In a case where the cycle of the step ST120 and the step ST122 is repeated a plurality of times as described above, the development conditions of the step ST120 and/or the step ST122 may be different between one or the plurality of cycles and another one or the plurality of cycles. For example, the temperature of the substrate support in the step ST120 may be lower in one or the plurality of cycles in which the development is performed to a second depth deeper than the first depth than in one or the plurality of cycles in which the development is performed to the first depth.

In an embodiment, the underlying film UF is subjected to etching processing after the step ST12. The etching processing may be performed, for example, by forming plasma from the processing gas in the processing chamber 10 of the plasma processing apparatus 1. In the etching processing, the resist film RM functions as a mask, and a concave portion is formed in the underlying film UF based on the shape of the opening OP. In a case where the development is performed using the plasma processing apparatus 1 in the step ST12, the etching processing may be continuously executed in the same processing chamber 10 as in the step ST12, or may be executed in the processing chamber 10 of another plasma processing apparatus 1.

### <Second Embodiment of Substrate Processing Method>

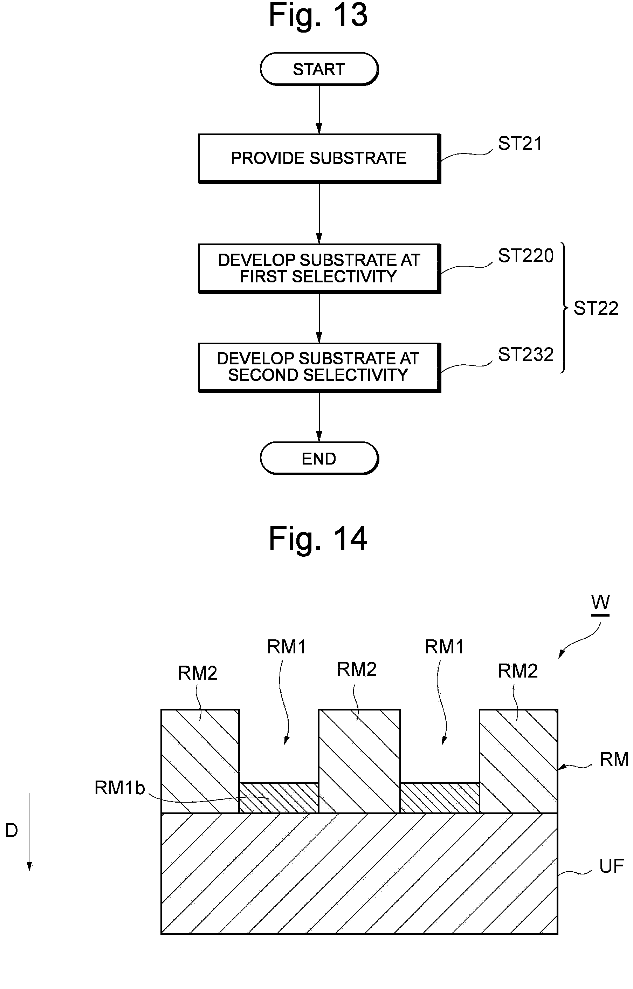

Figure 13 is a flowchart illustrating a substrate processing method according to an exemplary second embodiment (hereinafter, also referred to as a "second method"). As illustrated in Figure 13, the second method includes a step ST21 of providing a substrate and a step ST22 of developing the substrate.

In an embodiment, the development processing in the step ST22 is performed by dry development. In an embodiment, the development processing in the step ST22 is performed by wet development. In an embodiment, the development processing in the step ST22 is performed using both the wet development and the dry development.

The second method may be executed by the above-described heating processing system (Figure 1). In the following, a case where the controller 200 controls each unit of the heating processing apparatus 100 to execute the second method on the substrate W will be described as an example. The second method may be executed by combining the heating processing system (Figure 1) with other substrate processing systems such as the plasma processing system (Figures 2 and 3) and the liquid processing system (Figure 4).

### (Step ST21: Provision of Substrate)

First, in the step ST21, the substrate W is provided in the processing chamber 102 of the heating processing apparatus 100. The step ST21 is the same as the step ST11 of the first method, and the configuration of the substrate W may be the same as the configuration illustrated in Figure 6.

### (Step ST22: Development of Substrate)

Next, in step ST22, the resist film RM of the substrate W is developed, and the first region RM1 is selectively removed. The step ST22 includes a step ST220 of developing the substrate at the first selectivity and a step ST222 of developing the substrate at the second selectivity different from the first selectivity.

### (Step ST220: Development at First Selectivity)

First, in the step ST220, the processing gas including the development gas is supplied into the processing chamber 102 via the gas nozzle 141. The development gas may be a gas capable of selectively removing the first region with respect to the second region, unlike the step ST120 of the first method described above. As a result, the first region RM1 of the resist film RM is selectively removed with respect to the second region RM2.

In the step ST220, the first region RM1 of the resist film RM is removed at the first selectivity with respect to the second region RM2. In the second method, the "selectivity" is also referred to as a development contrast, and is a ratio of the development speed of the first region RM1 to the development speed of the second region RM2. The first selectivity may be appropriately set to a range (that is, a value greater than 1) in which the first region RM1 is selectively removed with respect to the second region RM2.

The step ST220 may be executed until the first region RM1 is removed to a given depth or until the opening formed by the development has a given aspect ratio. The given depth or aspect ratio may be set based on the degree of progress of the exposure reaction of the first region RM (in an example, based on the thickness of the first portion RM1a and the second portion RM1b). In an embodiment, the step ST220 may be executed until just before the second portion RM1b of the first region RM1 is removed or until a part thereof is removed.

Figure 14 is a view illustrating an example of a cross-sectional structure of the substrate W after processing in step ST220. In the example illustrated in Figure 14, the first region RM1 of the resist film RM is selectively removed with respect to the second region RM2, and the upper surface of the second portion RM1b of the first region is exposed.

### (Step ST222: Development at Second Selectivity)

In the step ST222, the processing gas including the development gas is supplied into the processing chamber 102 via the gas nozzle 141. The development gas may be the same as or different from the development gas used in the step ST220. As a result, the first region RM1 of the resist film RM is selectively etched with respect to the second region RM2.

In the step ST222, the first region RM1 of the resist film RM is removed at the second selectivity different from the first selectivity with respect to the second region RM2. The selectivity may be made different from the first selectivity by changing, for example, any one or more of development conditions such as the set temperature of the substrate W or the substrate support 11, the pressure in the processing chamber 102, and the type and concentration (partial pressure) of the processing gas from the step ST220.

In an embodiment, the second selectivity is higher than the first selectivity. For example, in step ST122, any one or more of the following (I) to (IV) may be executed to increase the second selectivity to be higher than the first selectivity.

(I) In the step ST222, the set temperature of the substrate W or the substrate support 121 is set to be lower than that in the step ST220.
(II) In the step ST222, the pressure in the processing chamber 102 is set to be higher than that in the step ST220.
(III) In the step ST222, the acidity of the development gas is set to be higher than the acidity of the development gas in the step ST220.
(IV) In the step ST222, the concentration (partial pressure) of the development gas in the processing gas is set to be higher than the concentration (partial pressure) of the development gas in the processing gas in the step ST220.

The step ST222 may be executed until the first region RM1 is removed and the underlying film UF is exposed. The step ST222 may be performed until the underlying film UF is partially removed (over-etched) in the depth direction.

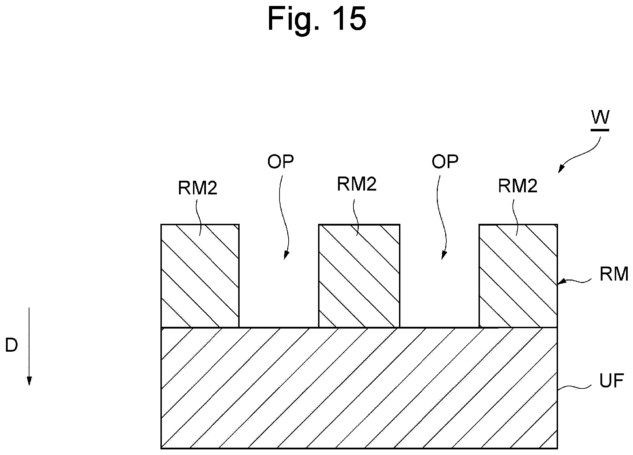

Figure 15 is a view illustrating an example of a cross-sectional structure of the substrate W after processing in step ST222. In the example illustrated in Figure 15, the first region RM1 of the resist film RM is removed, and the opening OP is formed. The opening OP is defined by the side surface of the second region RM2. The opening OP is a space on the underlying film UF surrounded by the side surface. The opening OP has a shape corresponding to the first region RM1 (as a result, a shape corresponding to the opening of the exposure mask used for the EUV exposure) in a plan view of the substrate W. The shape may be, for example, a circle, an ellipse, a rectangle, a line, or a shape in which one or more of these are combined. A plurality of openings OP may be formed in the resist film RM. The plurality of openings OP may each have a hole shape and constitute an array pattern arranged at regular intervals. The plurality of openings OP may each have a linear shape and may be arranged at regular intervals to form a line-and-space pattern.

According to the second method, a development pattern consisting of the second region RM2 that is not exposed is able to be formed by the development processing. As a result, a pattern (for example, a hole array pattern) different from the first method may be formed on the resist film RM. In addition, the second method includes a step ST220 of performing development at the first selectivity and a step ST222 of performing development at the second selectivity different from the first selectivity. In this manner, the shape of the development pattern is able to be adjusted. In addition, even in a case where the intensity of the exposure reaction is different in the thickness direction in the resist film RM, the first region RM1 is able to be removed with respect to the second region RM2 at an appropriate selectivity, and the deterioration of the pattern shape or the roughness may be suppressed.

In addition, the development processing in the step ST22 may be executed using the plasma processing apparatus and system (see Figures 2 and 3) and/or the liquid processing system (see Figure 4), as in the step ST12. In addition, in a case where the substrate W is subjected to dry development using the heating processing system or the plasma processing system, the second method may include the desorption step, as in the first method. The desorption step may be executed after the step ST22, or may be repeatedly executed one or a plurality of times between the development and the development in the step ST22.

In an embodiment, the development processing in the step ST22 may be performed by both the heating processing and the plasma processing. For example, the step ST220 may be executed by the heating processing and the step ST222 may be executed by the plasma processing, or the step ST220 may be executed by the plasma processing and the step ST222 may be executed by the heating processing.

In an embodiment, in the step ST22, the cycle including the step ST220 and the step ST222 may be repeated a plurality of times. In this case, the cycles of the step ST220 and the step ST222 may be repeated a plurality of times only by the dry development, or may be repeated a plurality of times only by the wet development. In addition, after performing the cycles of the step ST220 and the step ST222 once or more by the wet development, the cycles of the step ST220 and the step ST222 may be performed once or more by the dry development. In addition, the cycle of the step ST220 performed by the wet development and the step ST222 performed by the dry development may be repeated a plurality of times. In a case where the cycle of the step ST220 and the step ST222 is repeated a plurality of times as described above, development conditions of the step ST220 and/or the step ST222 may be different between one or a plurality of cycles and another one or a plurality of cycles. For example, the temperature of the substrate support in the step ST220 may be lower in one or a plurality of cycles in which the development is performed to the second depth deeper than the first depth than in one or a plurality of cycles in which the development is performed to the first depth.

In an embodiment, the underlying film UF is subjected to the etching processing after the step ST22. The etching processing may be performed, for example, by forming plasma from the processing gas in the processing chamber 10 of the plasma processing apparatus 1. In the etching processing, the resist film RM functions as a mask, and a concave portion is formed in the underlying film UF based on the shape of the opening OP. In a case where the development is performed using the plasma processing apparatus 1 in the step ST22, the etching processing may be continuously executed in the same processing chamber 10 as in the step ST22, or may be executed in the processing chamber 10 of another plasma processing apparatus 1.

### <Configuration Example of Substrate Processing System>

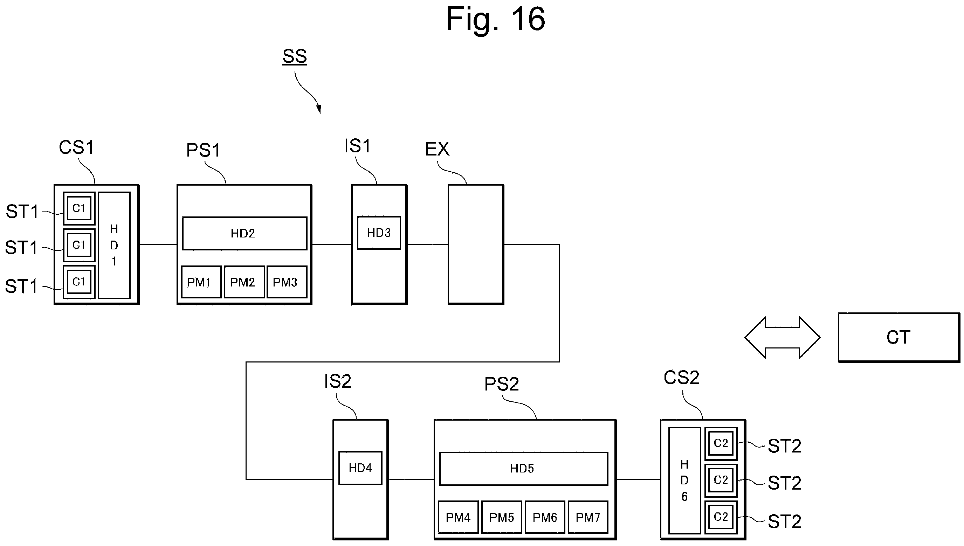

Figure 16 is a block diagram for describing a configuration example of a substrate processing system SS according to an exemplary embodiment. The substrate processing system SS includes a first carrier station CS1, a first processing station PS1, a first interface station IS1, an exposure apparatus EX, a second interface station IS2, a second processing station PS2, a second carrier station CS2, and a controller CT.

The first carrier station CS1 performs the carrying-in and carrying-out of the first carrier C1 between the first carrier station CS1 and an external system of the substrate processing system SS. The first carrier station CS1 has a stage including a plurality of first placing plates ST1. The first carrier C1 in a state where a plurality of substrates W is accommodated or in a state where the first carrier C1 is empty is placed on each first placing plate ST1. The first carrier C1 has a housing capable of accommodating the plurality of substrates W inside. In an example, the first carrier C1 is a front opening unified pod (FOUP).

In addition, the first carrier station CS1 transports the substrate W between the first carrier C1 and the first processing station PS1. The first carrier station CS1 further includes a first transport apparatus HD1. The first transport apparatus HD1 is provided at the first carrier station CS1 to be positioned between the stage and the first processing station PS1. The first transport apparatus HD1 transports and delivers the substrate W between the first carrier C1 on each first placing plate ST1 and the second transport apparatus HD2 of the first processing station PS1. The substrate processing system SS may further include a load lock module. The load lock module may be provided between the first carrier station CS1 and the first processing station PS1. The load lock module is able to switch the pressure inside thereof to atmospheric pressure or vacuum. The "atmospheric pressure" may be a pressure inside the first transport apparatus HD1. In addition, the "vacuum" is a pressure lower than the atmospheric pressure, and may be, for example, a medium vacuum of 0.1 Pa to 100 Pa. The inside of the second transport apparatus HD2 may be atmospheric pressure or vacuum. The load lock module may transport, for example, the substrate W from the first transport apparatus HD1, which is atmospheric pressure, to the second transport apparatus HD2, which is vacuum, and may transport the substrate W from the second transport apparatus HD2, which is vacuum, to the first transport apparatus HD1, which is atmospheric pressure.

The first processing station PS1 performs various types of processing on the substrate W. In an embodiment, the first processing station PS1 includes a preprocessing module PM1, a resist film forming module PM2, and a first heating processing module PM3 (hereinafter, also collectively referred to as a "first substrate processing module PMa"). In addition, the first processing station PS1 has a second transport apparatus HD2 that transports the substrate W. The second transport apparatus HD2 transports and delivers the substrate W between two designated first substrate processing modules PMa and between the first processing station PS1 and the first carrier station CS1 or the first interface station IS1.

In the preprocessing module PM1, the substrate W is subjected to the preprocessing. In an embodiment, the preprocessing module PM1 includes a temperature-controlled unit that adjusts the temperature of the substrate W, a high-precision temperature-controlled unit that adjusts the temperature of the substrate W with high precision, and the like. In an embodiment, the preprocessing module PM1 includes a surface reforming processor that performs surface reforming processing on the substrate W. Each processor of the preprocessing module PM1 may be configured to include the heating processing apparatus 100 (see Figure 1), the plasma processing apparatus 1 (see Figures 2 and 3), and/or the liquid processing apparatus 300 (see Figure 4).

In the resist film forming module PM2, the resist film is formed on the substrate W. In an embodiment, the resist film forming module PM2 includes a dry coating unit. The dry coating unit forms the resist film on the substrate W using a dry process such as a vapor deposition method. The dry coating unit includes, for example, a CVD apparatus or ALD apparatus that performs chemical vapor deposition on the resist film, or a PVD apparatus that performs physical vapor deposition on the resist film on the substrate W disposed in the chamber. The dry coating unit may be the heating processing apparatus 100 (see Figure 1) or the plasma processing apparatus 1 (see Figures 2 and 3).

In an embodiment, the resist film forming module PM2 includes a wet coating unit. The wet coating unit forms the resist film on the substrate W using a wet process such as a liquid phase deposition method. The wet coating unit may be, for example, the liquid processing apparatus 300 (see Figure 4).

In an embodiment, the example of the resist film forming module PM2 includes both the wet coating unit and the dry coating unit.

In the first heating processing module PM3, the substrate W is subjected to the heating processing. In an embodiment, the first heating processing module PM3 includes one or more of a pre-baking (PAB) unit that performs the heating processing on the substrate W on which the resist film is formed, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In one example, the plurality of heating processing apparatuses may be stacked. The heating processing apparatus may be, for example, the heating processing apparatus 100 (see Figure 1). Each heating processing may be performed at a predetermined temperature using a predetermined gas.

The first interface station IS1 includes a third transport apparatus HD3. The third transport apparatus HD3 transports and delivers the substrate W between the first processing station PS1 and the exposure apparatus EX. The third transport apparatus HD3 may be configured to have a housing that accommodates the substrate W, and a temperature, humidity, pressure, and the like in the housing are controllable.

In the exposure apparatus EX, the resist film on the substrate W is exposed using an exposure mask (reticle). The exposure apparatus EX may be, for example, an EUV exposure apparatus having a light source that generates EUV light.

The second interface station IS2 includes a fourth transport apparatus HD4. The fourth transport apparatus HD4 transports or delivers the substrate W between the exposure apparatus EX and the second processing station PS2. The fourth transport apparatus HD4 may be configured to have a housing that accommodates the substrate W, and the temperature, humidity, pressure, and the like in the housing may be controllable.

The second processing station PS2 performs various types of processing on the substrate W. In an embodiment, the second processing station PS2 includes a second heating processing module PM4, a measurement module PM5, a developing module PM6, and a third heating processing module PM7 (hereinafter, also collectively referred to as a "second substrate processing module PMb"). In addition, the second processing station PS2 has a fifth transport apparatus HD5 that transports the substrate W. The fifth transport apparatus HD5 transports and delivers the substrate W between the two designated second substrate processing modules PMb and between the second processing station PS2 and the second carrier station CS2 or the second interface station IS2.

In the second heating processing module PM4, the substrate W is subjected to the heating processing. In an embodiment, the heating processing module PM4 includes any one or more of a post-exposure baking (PEB) unit that performs the heating processing on the substrate W after exposure, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In one example, the plurality of heating processing apparatuses may be stacked. The heating processing apparatus may be, for example, the heating processing apparatus 100 (see Figure 1). Each heating processing may be performed at a predetermined temperature using a predetermined gas.

In the measurement module PM5, various measurements are performed on the substrate W. In an embodiment, the measurement module PM5 includes an imaging unit including a stage on which the substrate W is placed, an imaging apparatus, an illumination apparatus, and various sensors (a temperature sensor, a reflectivity measuring sensor, and the like). The imaging apparatus may be, for example, a CCD camera that images the appearance of the substrate W. Alternatively, the imaging apparatus may be a hyperspectral camera that images light by spectrally separating the light for each wavelength. The hyperspectral camera is able to measure any one or more of a pattern shape, a dimension, a film thickness, a composition, and a film density of the resist film.

In the developing module PM6, the substrate W is subjected to development processing. In an embodiment, the developing module PM6 includes a dry development unit that performs dry development on the substrate W. The dry development unit may be, for example, the heating processing apparatus 100 (see Figure 1) or the plasma processing apparatus 1 (see Figures 2 and 3). In an embodiment, the developing module PM6 includes a wet development unit that performs wet development on the substrate W. The wet development unit may be, for example, the liquid processing apparatus 300 (Figure 4). In an embodiment, the developing module PM6 includes both the dry development unit and the wet development unit.

In the third heating processing module PM7, the substrate W is subjected to the heating processing. In an embodiment, the third heating processing module PM7 includes any one or more of a post-baking (PB) unit that performs heating processing on the substrate W after development, a temperature-controlled unit that adjusts the temperature of the substrate W, and a high-precision temperature-controlled unit that adjusts the temperature of the substrate W with high precision. Each of these units may have one or a plurality of heating processing apparatuses, respectively. In one example, the plurality of heating processing apparatuses may be stacked. The heating processing apparatus may be, for example, the heating processing apparatus 100 (see Figure 1). Each heating processing may be performed at a predetermined temperature using a predetermined gas.

The second carrier station CS2 performs carrying-in and carrying-out of the second carrier C2 between the second carrier station CS2 and an external system of the substrate processing system SS. The configuration and the function of the second carrier station CS2 may be the same as those of the first carrier station CS1 described above.

The controller CT controls each configuration of the substrate processing system SS to execute given processing on the substrate W. The controller CT stores a recipe in which a process procedure, a process condition, a transport condition, and the like are set, and controls each configuration of the substrate processing system SS to execute given processing on the substrate W according to the recipe. The controller CT may serve as some or all of the functions of each controller (the controller 200 and the controller 2 illustrated in Figures 1 to 4 and the controller 400).

### <Example of Substrate Processing Method>

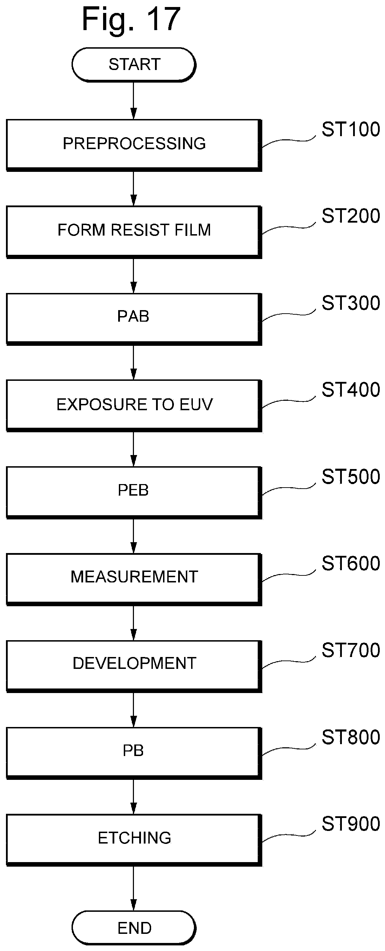

Figure 17 is a flowchart illustrating a substrate processing method (hereinafter, also referred to as a "method MT") according to an exemplary embodiment. As illustrated in Figure 17, the method MT includes a step ST100 of performing preprocessing on the substrate, a step ST200 of forming the resist film on the substrate, a step ST300 of performing heating processing (pre-baking: PAB) on the substrate on which the resist film is formed, a step ST400 of performing EUV exposure on the substrate, a step ST500 of performing heating processing (post-exposure baking: PEB) on the substrate after the exposure, a step ST600 of measuring the substrate, a step ST700 of developing the resist film on the substrate, a step ST800 of performing heating processing (post-baking: PB) on the substrate after the development, and a step ST900 of etching the substrate. The method MT may not include one or more of the above-described steps. For example, the method MT may not include the step ST600, and the step ST700 may be executed after the step ST500.

The method MT may be executed by using the substrate processing system SS illustrated in Figure 16. In the following, a case where the controller CT of the substrate processing system SS controls each unit of the substrate processing system SS to execute the method MT on the substrate W will be described as an example.

### (Step ST100: Preprocessing)

First, the first carrier C1 accommodating the plurality of substrates W is carried into the first carrier station CS1 of the substrate processing system SS. The first carrier C1 is placed on the first placing plate ST1. Next, each substrate W in the first carrier C1 is sequentially taken out by the first transport apparatus HD1 and delivered to the second transport apparatus HD2 of the first processing station PS1. The substrate W is transported to the preprocessing module PM1 by the second transport apparatus HD2. The preprocessing module PM1 performs the preprocessing on the substrate W. The preprocessing may include, for example, one or more of temperature adjustment of the substrate W, formation of a part or all of the underlying film of the substrate W, heating processing of the substrate W, and high-precision temperature adjustment of the substrate W. The preprocessing may include a surface reforming processing of the substrate W.

### (Step ST200: Resist Film Formation)

Next, the substrate W is transported to the resist film forming module PM2 by the second transport apparatus HD2. The resist film is formed on the substrate W by the resist film forming module PM2. In an embodiment, the resist film is formed by a wet process such as a liquid phase deposition method. For example, the resist film is formed by spin-coating the resist film on the substrate W using the wet coating unit of the resist film forming module PM2. In an embodiment, the resist film is formed on the substrate W by a dry process such as a vapor deposition method. For example, the resist film is formed by vapor-depositing the resist film on the substrate W using the dry coating unit of the resist film forming module PM2.

The resist film may be formed on the substrate W by using both the dry process and the wet process. For example, the second resist film may be formed on the first resist film by the wet process after the first resist film is formed on the substrate W by the dry process. In this case, the film thicknesses, materials, and/or compositions of the first resist film and the second resist film may be the same as or different from each other.

### (Step ST300: PAB)

Next, the substrate W is transported to the first heating processing module PM3 by the second transport apparatus HD2. The substrate W is subjected to the heating processing (pre-baking: PAB) by the first heating processing module PM3. The pre-baking may be performed in an air atmosphere or an inert atmosphere. In addition, the pre-baking may be performed by heating the substrate W to 50°C or higher or 80°C or higher. The heating temperature of the substrate W may be 250°C or lower, 200°C or lower, or 150°C or lower. In one example, the heating temperature of the substrate may be 50°C or higher and 250°C or lower. In a case where the resist film is formed by the dry process in the step ST200, in an embodiment, the pre-baking may be continuously executed by the dry coating unit that has executed the step ST200. In an embodiment, after the pre-baking, removing processing of the resist film at the end portion of the substrate W (edge bead removal: EBR) may be performed.

### (Step ST400: EUV Exposure)

Next, the substrate W is delivered to the third transport apparatus HD3 of the first interface station IS1 by the second transport apparatus HD2. Then, the substrate W is transported to the exposure apparatus EX by the third transport apparatus HD3. The substrate W is subjected to EUV exposure in the exposure apparatus EX through the exposure mask (reticle). As a result, on the substrate W, a first region where EUV exposure is performed and a second region where EUV exposure is not performed are formed corresponding to the pattern of the exposure mask (reticle).

### (Step ST500: PEB)

Next, the substrate W is delivered from the fourth transport apparatus HD4 of the second interface station IS2 to the fifth transport apparatus HD5 of the second processing station PS2. Then, the substrate W is transported to the second heating processing module PM4 by the fifth transport apparatus HD5. Then, the substrate W is subjected to the heating processing (post-exposure baking: PEB) in the second heating processing module PM4. The post-exposure baking may be performed in the air atmosphere. In addition, the post-exposure baking may be performed by heating the substrate W to 180°C or higher and 250°C or lower.

### (Step ST600: Measurement)

Next, the substrate W is transported to the measurement module PM5 by the fifth transport apparatus HD5. The measurement module PM5 measures the substrate W. The measurement may be an optical measurement or other measurements. In an embodiment, the measurement by the measurement module PM5 includes measurement of the appearance and/or dimensions of the substrate W using a CCD camera. In an embodiment, the measurement by the measurement module PM5 includes the measurement of any one or more of a pattern shape, a dimension, a film thickness, a composition, or a film density of a resist film using a hyperspectral camera (hereinafter, also referred to as "pattern shape and the like").

In an embodiment, the controller CT determines the presence or absence of the exposure abnormality of the substrate W based on the measured appearance, dimensions, and/or pattern shape, and the like of the substrate W. In an embodiment, in a case where the controller CT determines that there is an exposure abnormality, the substrate W may be reworked or discarded without performing the development in step ST700. The rework of the substrate W may be performed by removing the resist on the substrate W and returning to the step ST200 to form the resist film again. The rework after development may cause damage to the substrate W, but damage to the substrate W may be avoided or suppressed by performing the rework before development.

### (Step ST700: Development)

Next, the substrate W is transported to the developing module PM6 by the fifth transport apparatus HD5. In the developing module PM6, the resist film of the substrate W is developed. The development processing may be performed by the dry development or the wet development. The development processing may be performed by combining the dry development and the wet development. The development processing in the step ST700 may be performed by the first method (see Figures 5 and 11) or the second method (see Figure 12). Desorption processing may be executed once or more after the development processing or during the development processing. The desorption processing includes removing (descumming) a scum from the surface of the resist film or smoothing the surface with an inert gas such as helium or plasma of the inert gas. In addition, in the developing module PM6, after the development processing, a part of the underlying film may be etched using the developed resist film as a mask.

### (Step ST800: PB)

Next, the substrate W is transported to the third heating processing module PM7 by the fifth transport apparatus HD5 and is subjected to the heating processing (post-baking). The post-baking may be performed in an air atmosphere or a reduced pressure atmosphere containing N₂ or O₂. In addition, the post-baking may be performed by heating the substrate W to 150°C or higher and 250°C or lower. The post-baking may be performed by the second heating processing module PM4 instead of the third heating processing module PM7. In an embodiment, the optical measurement of the substrate W may be performed by the measurement module PM5 after the post-baking. Such measurement may be executed in addition to the measurement in the step ST600 or instead of the measurement in the step ST600. In an embodiment, the controller CT determines the presence or absence of an abnormality such as a defect, a scratch, or an adhesion of a foreign substance in the development pattern of the substrate W based on the measured appearance and dimensions of the substrate W and/or the pattern shape, and the like. In an embodiment, in a case where the controller CT determines that an abnormality has occurred, the substrate W may be reworked or discarded without performing the etching in step ST900. In an embodiment, in a case where the controller CT determines that an abnormality is present, the opening dimensions of the resist film of the substrate W may be adjusted by using the dry coating unit (CVD apparatus, ALD apparatus, or the like).

### (Step ST900: Etching)

After the execution of the step ST800, the substrate W is delivered to the sixth transport apparatus HD6 of the second carrier station CS2 by the fifth transport apparatus HD5, and is transported to the second carrier C2 of the second placing plate ST2 by the sixth transport apparatus HD6. Thereafter, the second carrier C2 is transported to a plasma processing system (not illustrated). The plasma processing system may be, for example, the plasma processing system illustrated in Figures 2 and 3. In the plasma processing system, the underlying film UF of the substrate W is etched using the resist film after development as a mask. As described above, the method MT ends. In a case where the resist film is developed using a plasma processing apparatus in step ST700, the etching may be continuously executed in the plasma processing chamber of the plasma processing apparatus. In addition, in a case where the second processing station PS2 includes a plasma processing module in addition to the developing module PM6, the etching may be executed in the plasma processing module. The above-described desorption processing may be executed once or more before or during the etching.

The embodiments of the present disclosure further include the following aspects.

### (Addendum 1)

A substrate processing method including:
(a) providing a substrate on a substrate support, the substrate having an underlying film and a metal-containing resist film on the underlying film, the metal-containing resist film including a first region and a second region; and
(b) developing the metal-containing resist film to selectively remove the second region from the metal-containing resist film, in which
   the (b) includes
(b1) removing the second region with respect to the first region at a first selectivity, and
(b2) further removing the second region with respect to the first region at a second selectivity different from the first selectivity.

### (Addendum 2)

The substrate processing method according to Addendum 1, in which the first region is an exposed region, and the second region is an unexposed region.

### (Addendum 3)

The substrate processing method according to Addendum 1 or 2, in which the second selectivity is higher than the first selectivity.

### (Addendum 4)

The substrate processing method according to any one of Addendums 1 to 3, in which
in the (b), the development is performed by wet development, and
the (b) satisfies at least one of
   (I) a solubility of the metal-containing resist film with respect to a developer used in the (b2) is lower than a solubility of the metal-containing resist film with respect to a developer used in the (b1),
   (II) a concentration of the developer used in the (b2) is lower than a concentration of the developer used in the (b1), and
   (III) a temperature of the developer used in the (b2) is lower than a temperature of the developer used in the (b1).

### (Addendum 5)

The substrate processing method according to any one of Addendums 1 to 3, in which
in (b), the development is performed by dry development in a chamber, and
the (b) satisfies at least one of
   (I) a temperature of the substrate support in the (b2) is lower than a temperature of the substrate support in the (b1),
   (II) a pressure in a chamber in the (b2) is lower than a pressure in a chamber in the (b1),
   (III) an acidity of a second development gas used in the (b2) is lower than an acidity of a first development gas used in the (b1), and
   (IV) a concentration of the second development gas used in the (b2) is lower than a concentration of the first development gas used in the (b1).

### (Addendum 6)

The substrate processing method according to any one of Addendums 1 to 3, in which
the (b1) is performed by dry development using a first processing gas including a first development gas,
the (b2) is performed by dry development using a second processing gas including a second development gas, and
the (b) satisfies at least one of
   (I) a temperature of the substrate support in the (b2) is lower than a temperature of the substrate support in the (b1),
   (II) a pressure in a chamber in the (b2) is lower than a pressure in a chamber in the (b1),
   (III) an acidity of the second development gas is lower than an acidity of the first development gas,
   (IV) a concentration of the second development gas is lower than a concentration of the first development gas, and
   (V) the second processing gas includes a protective gas that protects a side wall of the first region exposed in the (b1) and the (b2), and the first processing gas does not include the protective gas, or includes the protective gas at a partial pressure lower than a partial pressure of the protective gas included in the second processing gas.

### (Addendum 7)

The substrate processing method according to any one of Addendums 1 to 3, in which
in the (b), the development is performed by dry development using plasma generated in a chamber, and
the (b) satisfies at least one of
   (I) a level of power of a source RF signal for generating plasma supplied to the chamber in the (b2) is lower than a level of power of a source RF signal in the (b1), and
   (II) a level of power or voltage of a bias signal supplied to the chamber in the (b2) is lower than a level of power or voltage of a bias signal in the (b1).

### (Addendum 8)

The substrate processing method according to any one of Addendums 1 to 7, in which the (b) further includes reforming the first region between the (b1) and the (b2).

### (Addendum 9)

The substrate processing method according to Addendum 8, in which reforming the first region includes heating or plasma-processing the substrate.

### (Addendum 10)

The substrate processing method according to Addendum 8 or 9, in which reforming the first region is executed in the same chamber as the (b1).

### (Addendum 11)

The substrate processing method according to Addendum 8 or 9, in which the reforming the first region is executed in a chamber different from the (b1).

### (Addendum 12)

The substrate processing method according to any one of Addendums 1 to 3, in which in the (b1), the development is performed by wet development, and in the (b2), the development is performed by dry development.

### (Addendum 13)

The substrate processing method according to any one of Addendums 1 to 12, in which in the (b), a cycle including the (b1) and the (b2) is repeated a plurality of times.

### (Addendum 14)

The substrate processing method according to any one of Addendums 1 to 13, in which the metal-containing resist film contains at least one metal selected from the group consisting of Sn, Hf, and Ti.

### (Addendum 15)

The substrate processing method according to any one of Addendums 1 to 14, in which the first region is exposed to EUV.

### (Addendum 16)

The substrate processing method according to any one of Addendums 1 to 15, in which switching from the (b1) to the (b2) is performed based on a depth or an aspect ratio of an opening formed in the metal-containing resist film by the development.

### (Addendum 17)

The substrate processing method according to any one of Addendums 1 to 16, in which
the first region includes a first portion and a second portion on the underlying film below the first portion, and
the (b1) is executed until just before the second portion is exposed or until a part of the second portion is exposed.

### (Addendum 18)

The substrate processing method according to any one of Addendums 1 to 17, further including:
(c) etching the underlying film using the metal-containing resist film as a mask after the (b).

### (Addendum 19)

The substrate processing method according to Addendum 18, further including at least one of:
removing a residue of the first region or the second region generated in (b1) after the (b1) and before the (b2); and
removing a residue of the first region or the second region generated in the (b1) and/or the (b2) after the (b2) and before the (c).

### (Addendum 20)

The substrate processing method according to Addendum 18 or 19, in which the (c) is executed in the same chamber as a chamber used in the (b).

### (Addendum 21)

The substrate processing method according to Addendum 18 or 19, in which the (c) is executed in a chamber different from a chamber used in the (b).

### (Addendum 22)

A substrate processing method including:
(a) providing a substrate on a substrate support, the substrate having an underlying film and a metal-containing resist film formed on the underlying film, the metal-containing resist film having an exposed first region and an unexposed second region; and
(b) dry-developing the metal-containing resist film to selectively remove the second region from the metal-containing resist film, in which
the (b) includes
(b1) controlling a temperature of the substrate support to a first temperature to remove the second region, and
(b2) controlling the temperature of the substrate support to a second temperature lower than the first temperature to remove the second region.

### (Addendum 23)

The substrate processing method according to Addendum 22, in which the (b) is the dry-developing using HBr, the first temperature is 20°C or higher and 60°C or lower, and the second temperature is -20°C or higher and 20°C or lower.

### (Addendum 24)

A substrate processing method including:
(a) providing a substrate on a substrate support, the substrate having an underlying film and a metal-containing resist film formed on the underlying film, the metal-containing resist film having an exposed first region and an unexposed second region; and
(b) dry-developing the metal-containing resist film to selectively remove the second region from the metal-containing resist film, in which
the (b) includes
(b1) removing the second region using a first processing gas, and
(b2) removing the second region using a second processing gas having a lower acidity than the first processing gas.

### (Addendum 25)

The substrate processing method according to Addendum 24, in which
the first processing gas includes a halogen-containing inorganic acid, and
the second processing gas includes an organic acid.

### (Addendum 26)

The substrate processing method according to Addendum 24 or 25, in which
the first processing gas includes a halogen-containing inorganic acid and an organic acid having a lower flow rate than the halogen-containing inorganic acid, and
the second processing gas includes a halogen-containing inorganic acid and an organic acid having a higher flow rate than the halogen-containing inorganic acid.

### (Addendum 27)

The substrate processing method according to Addendum 25 or 26, in which the halogen-containing inorganic acid includes at least one selected from the group consisting of an HBr gas, an HCl gas, a BCl₃ gas, an HF gas, and an HI gas.

### (Addendum 28)

The substrate processing method according to any one of Addendums 25 to 27, in which the organic acid includes at least one selected from the group consisting of a carboxylic acid, a β-dicarbonyl compound, and an alcohol.

### (Addendum 29)

The substrate processing method according to any one of Addendums 24 to 28, in which
the (b) satisfies at least one of
(I) a temperature of the substrate support in the (b2) is lower than a temperature of the substrate support in the (b1), and
(II) a pressure in a chamber in the (b2) is lower than a pressure in a chamber in the (b1).

### (Addendum 30)

The substrate processing method according to any one of Addendums 24 to 29, in which in the (b), the (b1) and the (b2) are repeated.

### (Addendum 31)

The substrate processing method according to any one of Addendums 24 to 30, in which in the (b), after a cycle including the (b1) and the (b2) is performed once or more, the (b1) is further performed.

### (Addendum 32)

The substrate processing method according to any one of Addendums 24 to 31, in which the (b) includes
removing the second region using plasma generated from the first processing gas and/or the second processing gas after a cycle including the (b1) and the (b2) is executed once or more without using plasma.

### (Addendum 33)

A substrate processing system including:
one or a plurality of substrate processing apparatuses; and
a controller, in which
the controller is configured to cause, with respect to the one or the plurality of substrate processing apparatuses,
   (a) providing a substrate on a substrate support, the substrate having an underlying film and a metal-containing resist film on the underlying film, the metal-containing resist film including a first region and a second region, and
   (b) developing the metal-containing resist film to selectively remove the second region from the metal-containing resist film, and
   the (b) includes
   (b1) removing the second region with respect to the first region at a first selectivity, and
   (b2) further removing the second region with respect to the first region at a second selectivity different from the first selectivity.

Each of the above embodiments is described for the purpose of description, and is not intended to limit the scope of the present disclosure. Each of the above embodiments may be modified in various ways without departing from the scope and purpose of the present disclosure. For example, some configuration elements in one embodiment is able to be added to other embodiments. In addition, some configuration elements in one embodiment are able to be replaced with corresponding components in another embodiment.

### Reference Signs List

- 1: plasma processing apparatus
- 2: controller
- 10: plasma processing chamber
- 11: substrate support
- 20: gas supply
- 30: power supply
- 100: heating processing apparatus
- 102: processing chamber
- 120: stage heater
- 121: substrate support
- 141: gas nozzle
- 200: controller
- 300: liquid processing apparatus
- 311: spin chuck
- 321: cup
- 331: processing liquid supply nozzle
- 351: cleaning liquid supply nozzle
- 400: controller
- OP: opening
- RM: resist film
- RM1: first region
- RM2: second region
- UF: underlying film
- W: substrate

## Claims

1. A substrate processing method comprising:
(a) providing a substrate on a substrate support, the substrate having an underlying film and a metal-containing resist film on the underlying film, the metal-containing resist film including a first region and a second region; and
(b) developing the metal-containing resist film to selectively remove the second region from the metal-containing resist film, wherein
the (b) includes
(b1) removing the second region with respect to the first region at a first selectivity, and
(b2) further removing the second region with respect to the first region at a second selectivity different from the first selectivity.

2. The substrate processing method according to Claim 1, wherein the first region is an exposed region, and the second region is an unexposed region.

3. The substrate processing method according to Claim 1, wherein the second selectivity is higher than the first selectivity.

4. The substrate processing method according to Claim 1, wherein
in the (b), the development is performed by wet development, and
the (b) satisfies at least one of
(I) a solubility of the metal-containing resist film with respect to a developer used in the (b2) is lower than a solubility of the metal-containing resist film with respect to a developer used in the (b1),
(II) a concentration of the developer used in the (b2) is lower than a concentration of the developer used in the (b1), and
(III) a temperature of the developer used in the (b2) is lower than a temperature of the developer used in the (b1).

5. The substrate processing method according to Claim 1, wherein
in (b), the development is performed by dry development in a chamber, and
the (b) satisfies at least one of
(I) a temperature of the substrate support in the (b2) is lower than a temperature of the substrate support in the (b1),
(II) a pressure in a chamber in the (b2) is lower than a pressure in a chamber in the (b1),
(III) an acidity of a second development gas used in the (b2) is lower than an acidity of a first development gas used in the (b1), and
(IV) a concentration of the second development gas used in the (b2) is lower than a concentration of the first development gas used in the (b1).

6. The substrate processing method according to Claim 1, wherein
the (b1) is performed by dry development using a first processing gas including a first development gas,
the (b2) is performed by dry development using a second processing gas including a second development gas, and
the (b) satisfies at least one of
(I) a temperature of the substrate support in the (b2) is lower than a temperature of the substrate support in the (b1),
(II) a pressure in a chamber in the (b2) is lower than a pressure in a chamber in the (b1),
(III) an acidity of the second development gas is lower than an acidity of the first development gas,
(IV) a concentration of the second development gas is lower than a concentration of the first development gas, and
(V) the second processing gas includes a protective gas that protects a side wall of the first region exposed in the (b1) and the (b2), and the first processing gas does not include the protective gas, or includes the protective gas at a partial pressure lower than a partial pressure of the protective gas included in the second processing gas.

7. The substrate processing method according to Claim 1, wherein
in the (b), the development is performed by dry development using plasma generated in a chamber, and
the (b) satisfies at least one of
(I) a level of power of a source RF signal for generating plasma supplied to the chamber in the (b2) is lower than a level of power of a source RF signal in the (b1), and
(II) a level of power or voltage of a bias signal supplied to the chamber in the (b2) is lower than a level of power or voltage of a bias signal in the (b1).

8. The substrate processing method according to Claim 1, wherein the (b) further includes reforming the first region between the (b1) and the (b2).

9. The substrate processing method according to Claim 8, wherein reforming the first region includes heating or plasma-processing the substrate.

10. The substrate processing method according to Claim 8, wherein reforming the first region is executed in the same chamber as the (b1).

11. The substrate processing method according to Claim 8, wherein the reforming the first region is executed in a chamber different from the (b1).

12. The substrate processing method according to Claim 1, wherein in the (b1), the development is performed by wet development, and in the (b2), the development is performed by dry development.

13. The substrate processing method according to Claim 1, wherein in the (b), a cycle including the (b1) and the (b2) is repeated a plurality of times.

14. The substrate processing method according to any one of Claims 1 to 13, wherein the metal-containing resist film contains at least one metal selected from the group consisting of Sn, Hf, and Ti.

15. The substrate processing method according to any one of Claims 1 to 13, wherein the first region is exposed to EUV.

16. The substrate processing method according to any one of Claims 1 to 13, wherein switching from the (b1) to the (b2) is performed based on a depth or an aspect ratio of an opening formed in the metal-containing resist film by the development.

17. The substrate processing method according to any one of Claims 1 to 13, wherein
the first region includes a first portion and a second portion on the underlying film below the first portion, and
the (b1) is executed until just before the second portion is exposed or until a part of the second portion is exposed.

18. The substrate processing method according to any one of Claims 1 to 13, further comprising:
(c) etching the underlying film using the metal-containing resist film as a mask after the (b).

19. The substrate processing method according to Claim 18, further comprising at least one of:
removing a residue of the first region or the second region generated in (b1) after the (b1) and before the (b2); and
removing a residue of the first region or the second region generated in the (b1) and/or the (b2) after the (b2) and before the (c).

20. The substrate processing method according to Claim 18, wherein the (c) is executed in the same chamber as a chamber used in the (b).

21. The substrate processing method according to Claim 18, wherein the (c) is executed in a chamber different from a chamber used in the (b).

22. A substrate processing method comprising:
(a) providing a substrate on a substrate support, the substrate having an underlying film and a metal-containing resist film formed on the underlying film, the metal-containing resist film having an exposed first region and an unexposed second region; and
(b) dry-developing the metal-containing resist film to selectively remove the second region from the metal-containing resist film, wherein
the (b) includes
(b1) controlling a temperature of the substrate support to a first temperature to remove the second region, and
(b2) controlling the temperature of the substrate support to a second temperature lower than the first temperature to remove the second region.

23. The substrate processing method according to Claim 22, wherein the (b) is the dry-developing using HBr, the first temperature is 20°C or higher and 60°C or lower, and the second temperature is -20°C or higher and 20°C or lower.

24. A substrate processing method comprising:
(a) providing a substrate on a substrate support, the substrate having an underlying film and a metal-containing resist film formed on the underlying film, the metal-containing resist film having an exposed first region and an unexposed second region; and
(b) dry-developing the metal-containing resist film to selectively remove the second region from the metal-containing resist film, wherein
the (b) includes
(b1) removing the second region using a first processing gas, and
(b2) removing the second region using a second processing gas having a lower acidity than the first processing gas.

25. The substrate processing method according to Claim 24, wherein
the first processing gas includes a halogen-containing inorganic acid, and
the second processing gas includes an organic acid.

26. The substrate processing method according to Claim 24, wherein
the first processing gas includes a halogen-containing inorganic acid and an organic acid having a lower flow rate than the halogen-containing inorganic acid, and
the second processing gas includes a halogen-containing inorganic acid and an organic acid having a higher flow rate than the halogen-containing inorganic acid.

27. The substrate processing method according to Claim 25 or 26, wherein the halogen-containing inorganic acid includes at least one selected from the group consisting of an HBr gas, an HCl gas, a BCl₃ gas, an HF gas, and an HI gas.

28. The substrate processing method according to Claim 25 or 26, wherein the organic acid includes at least one selected from the group consisting of a carboxylic acid, a β-dicarbonyl compound, and an alcohol.

29. The substrate processing method according to Claim 24, wherein
the (b) satisfies at least one of
(I) a temperature of the substrate support in the (b2) is lower than a temperature of the substrate support in the (b1), and
(II) a pressure in a chamber in the (b2) is lower than a pressure in a chamber in the (b1).

30. The substrate processing method according to Claim 24, wherein in the (b), the (b1) and the (b2) are repeated.

31. The substrate processing method according to Claim 24, wherein in the (b), after a cycle including the (b1) and the (b2) is performed once or more, the (b1) is further performed.

32. The substrate processing method according to Claim 24, wherein the (b) includes
removing the second region using plasma generated from the first processing gas and/or the second processing gas after a cycle including the (b1) and the (b2) is executed once or more without using plasma.

33. A substrate processing system comprising:
one or a plurality of substrate processing apparatuses; and
a controller, wherein
the controller is configured to cause, with respect to the one or the plurality of substrate processing apparatuses,
(a) providing a substrate on a substrate support, the substrate having an underlying film and a metal-containing resist film on the underlying film, the metal-containing resist film including a first region and a second region, and
(b) developing the metal-containing resist film to selectively remove the second region from the metal-containing resist film, and
the (b) includes
(b1) removing the second region with respect to the first region at a first selectivity, and
(b2) further removing the second region with respect to the first region at a second selectivity different from the first selectivity.
